# EUROPEAN PATENT APPLICATION

(11) **EP 4 293 724 A1**
(43) Date of publication of application: **20.12.2023**
(21) Application number: 23172203.4
(22) Date of filing: 09.05.2023
(51) Int. Cl.: H01L 29/06, H01L 21/822, H01L 21/8234, H01L 27/088, H01L 29/08, H01L 29/161, H01L 29/40, H01L 29/417, H01L 29/423, H01L 29/66, H01L 29/775, B82Y 10/00

(54) **SOURCE AND DRAIN CONTACTS FORMED USING SACRIFICIAL REGIONS OF SOURCE AND DRAIN**

(30) Priority: 13.06.2022 US 202217838646
(71) Applicant: INTEL Corporation, Santa Clara, CA 95054 (US)
(72) Inventor: GALATAGE, Rohit, Hillsboro, 97123 (US); RACHMADY, Willy, Beaverton, 97007 (US); RAFIQUE, Subrina, Beaverton, 97007 (US); KUMAR, Nitesh, Beaverton, 97006 (US); HUANG, Cheng-Ying, Hillsboro, 97124 (US); WIEDEMER, Jami A., Scappoose, 97056 (US); THOMAS, Nicole K., Portland, 97209 (US); QAYYUM, Munzarin F., Hillsboro, 97124 (US); MORROW, Patrick, Portland, 97229 (US); RADOSAVLJEVIC, Marko, Portland, 97229 (US); KOBRINSKY, Mauro J., Portland, 97229 (US)
(74) Representative: Goddar, Heinz J.

(57) **Abstract**

An integrated circuit structure includes a device including a source region (104a, 105a, 133a), a drain region (104b, 105b, 133b), a body (103) laterally between the source and drain regions, and a source contact (118a, 135) coupled to the source region. The source region includes a first region (105a), and a second region (133a) compositionally different from and above the first region. The source contact (118a, 135) extends through, and is in direct contact with, the second region (133a) and extends within and is in direct contact with the first region (105a). In an example where the device is a p-channel metal-oxide-semiconductor (PMOS) device, a concentration of germanium within the second region is different (e.g., higher) than a concentration of germanium within the first region. In another example where the device is a n-channel metal-oxide-semiconductor (NMOS) device, a doping concentration level of a dopant (e.g., an n-type dopant) within the second region is different (e.g., higher) from a doping concentration level of the dopant within the first region.

## Description

### FIELD OF THE DISCLOSURE

The present disclosure relates to integrated circuits, and more particularly, to source and drain contact structures.

### BACKGROUND

Semiconductor devices are electronic components that exploit the electronic properties of semiconductor materials, such as silicon (Si), germanium (Ge), gallium arsenide (GaAs), and indium phosphide (InP). A field-effect transistor (FET) is a semiconductor device that includes three terminals: a gate, a source, and a drain. A FET uses an electric field applied by the gate to control the electrical conductivity of a channel through which charge carriers (e.g., electrons or holes) flow between the source and drain. In instances where the charge carriers are electrons, the FET is referred to as an n-channel device; and in instances where the charge carriers are holes, the FET is referred to as a p-channel device. Some FETs have a fourth terminal called the body or substrate, which can be used to bias the transistor. In addition, metal-oxide-semiconductor FETs (MOSFETs) include a gate dielectric between the gate and the channel. MOSFETs may also be known as metal-insulator-semiconductor FETs (MISFETSs) or insulated-gate FETs (IGFETs). Complementary MOS (CMOS) structures use a combination of p-channel MOSFET (PMOS) and n-channel MOSFET (NMOS) devices to implement logic gates and other digital circuits.

A FinFET is a MOSFET transistor built around a thin strip of semiconductor material (generally referred to as a fin). The conductive channel of the FinFET device resides on the outer portions of the fin adjacent to the gate dielectric. Specifically, current runs along/within both sidewalls of the fin (sides perpendicular to the substrate surface) as well as along the top of the fin (side parallel to the substrate surface). Because the conductive channel of such configurations includes three different planer regions of the fin (e.g., top and two sides), such a FinFET design is sometimes referred to as a tri-gate transistor. A gate-all-around (GAA) transistor (sometimes referred to as a nanoribbon or nanowire transistor) is configured similarly to a fin-based transistor, but instead of a finned channel region, one or more channel bodies such as nanoribbons or nanowires extend between the source and the drain regions. In GAA transistors, the gate material wraps around each nanoribbon (hence, gate-all-around).

### BRIEF DESCRIPTION OF THE DRAWINGS

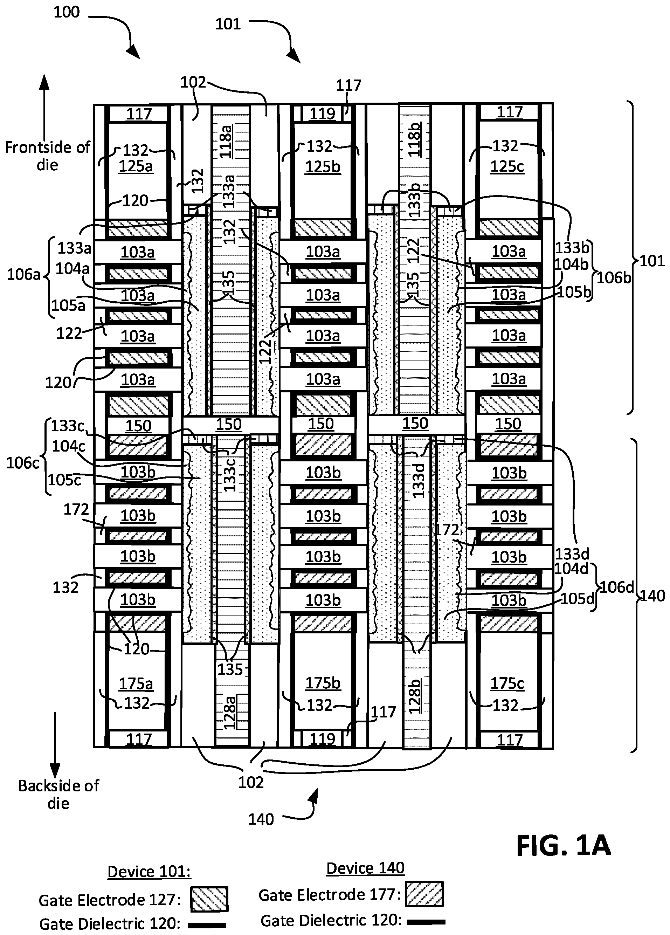

**Fig. 1A** illustrates a cross-section view of an integrated circuit structure including a vertically stacked architecture having an upper device above a lower device, wherein the integrated circuit structure comprises (i) a first source contact and a first drain contact of the upper device, (ii) a second source contact and a second drain contact of the lower device, (iii) remnants of a first core region of a source region of the upper device, (iv) remnants of a second core region of a drain region of the upper device, (iii) remnants of a third core region of a source region of the lower device, (iv) remnants of a fourth core region of a drain region of the lower device, wherein at least a central section of a core region of a source or drain region is removed during formation of a corresponding source or drain contact, leaving behind the remnants of the core region, in accordance with an embodiment of the present disclosure.

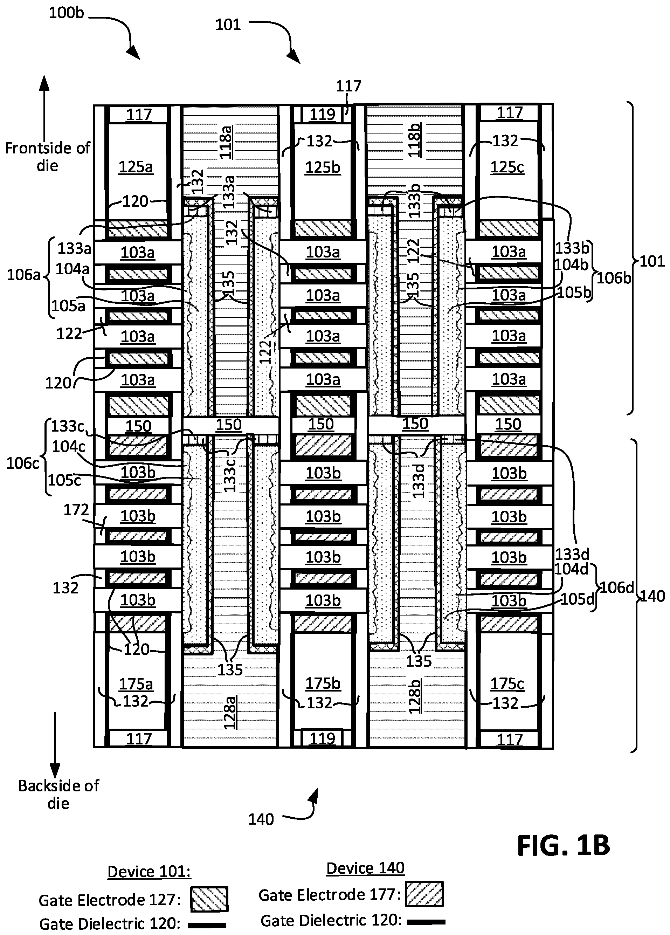

**Fig. 1B** illustrates a cross-section view of an integrated circuit structure including a vertically stacked architecture having an upper device above a lower device, wherein the integrated circuit structure comprises (i) a first source contact and a first drain contact of the upper device, (ii) a second source contact and a second drain contact of the lower device, (iii) remnants of a first core region of a source region of the upper device, (iv) remnants of a second core region of a drain region of the upper device, (iii) remnants of a third core region of a source region of the lower device, (iv) remnants of a fourth core region of a drain region of the lower device, wherein at least a section of a core region of a source or drain region is removed during formation of a corresponding source or drain contact, leaving behind the remnants of the core region, wherein in the upper device, individual remnant of the core regions is vertically between a corresponding source or drain contact and a corresponding main region, in accordance with an embodiment of the present disclosure.

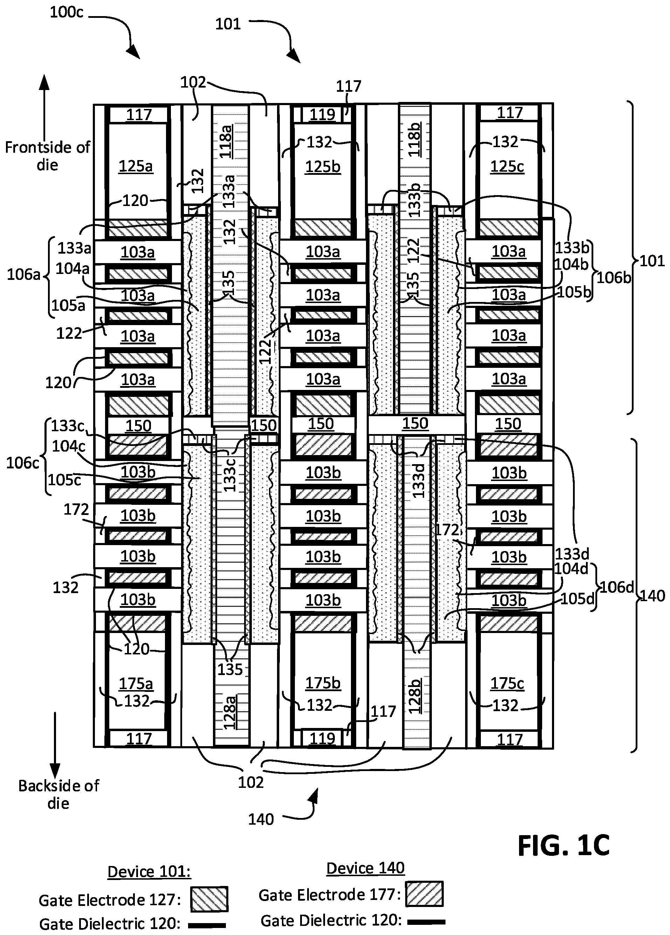

**Fig. 1C** illustrates a cross-section view of an integrated circuit structure including a vertically stacked architecture having an upper device above a lower device, wherein the integrated circuit structure comprises (i) a first source contact and a first drain contact of the upper device, (ii) a second source contact and a second drain contact of the lower device, (iii) remnants of a first core region of a source region of the upper device, (iv) remnants of a second core region of a drain region of the upper device, (iii) remnants of a third core region of a source region of the lower device, (iv) remnants of a fourth core region of a drain region of the lower device, wherein at least a section of a core region of a source or drain region is removed during formation of a corresponding source or drain contact, leaving behind the remnants of the core region, wherein a source contact (or a drain contact) of the upper device is in contact with a source contact (or a drain contact) of the lower device, in accordance with an embodiment of the present disclosure.

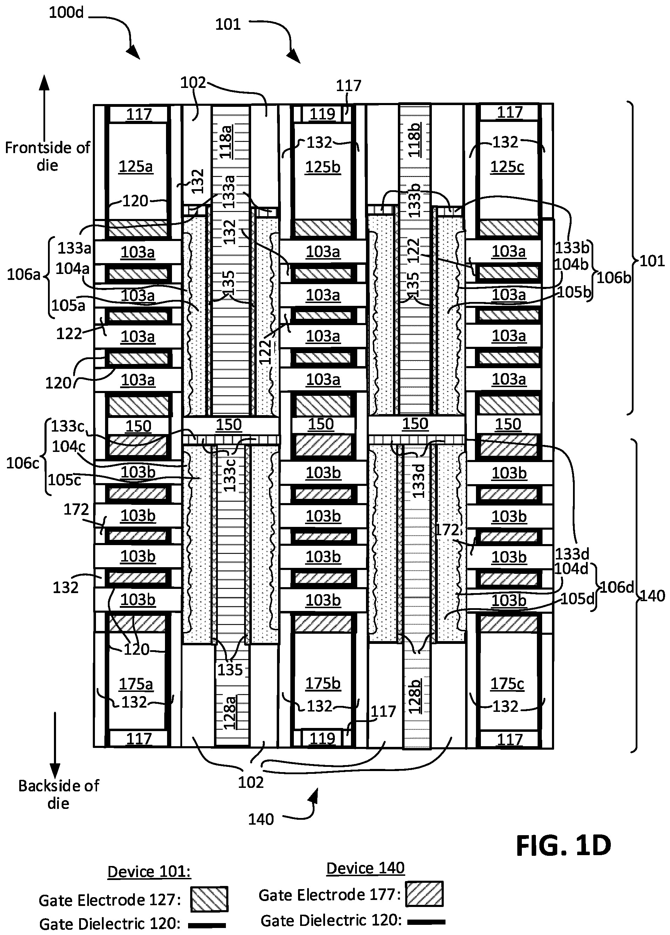

**Fig. 1D** illustrates a cross-section view of an integrated circuit structure including a vertically stacked architecture having an upper device above a lower device, wherein the integrated circuit structure comprises (i) a first source contact and a first drain contact of the upper device, (ii) a second source contact and a second drain contact of the lower device, (iii) remnants of a first core region of a source region of the upper device, (iv) remnants of a second core region of a drain region of the upper device, (iii) a third core region of a source region of the lower device, (iv) a fourth core region of a drain region of the lower device, wherein at least a section of the core regions of the source and drain region of the upper and lower devices are removed during formation of a corresponding source or drain contact, leaving behind the remnants of the core regions in the upper and lower devices, and wherein each of the source and drain regions of the lower device has a continuous core region within which the corresponding source or drain contact does not extend, in accordance with an embodiment of the present disclosure.

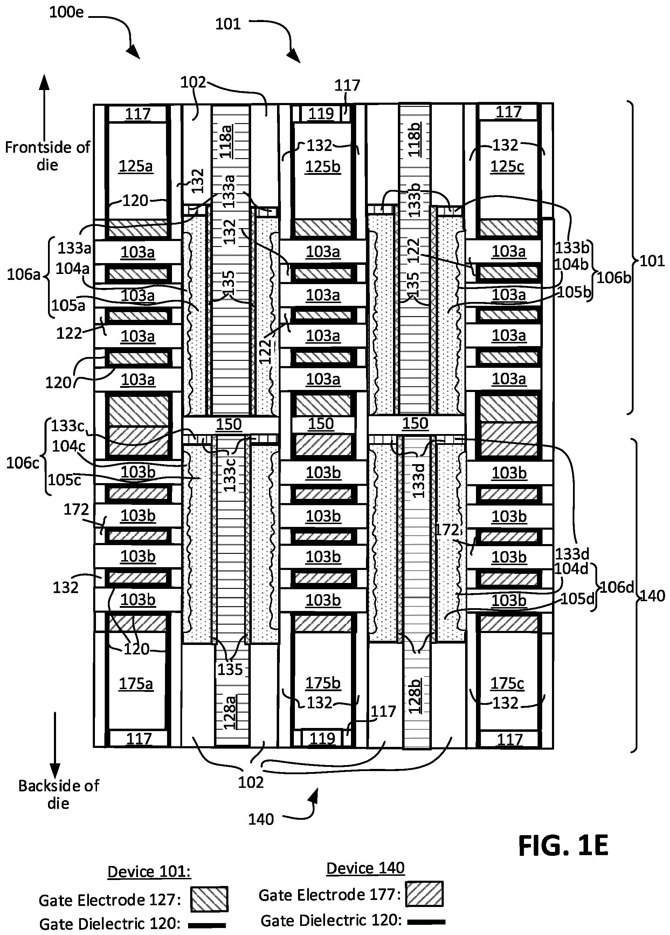

**Fig. 1E** illustrates a cross-section view of an integrated circuit structure that is at least in part similar to the integrated circuit structure of Fig. 1A, and where a gate electrode of the upper device and a gate electrode of the lower device are conductively coupled, in accordance with an embodiment of the present disclosure.

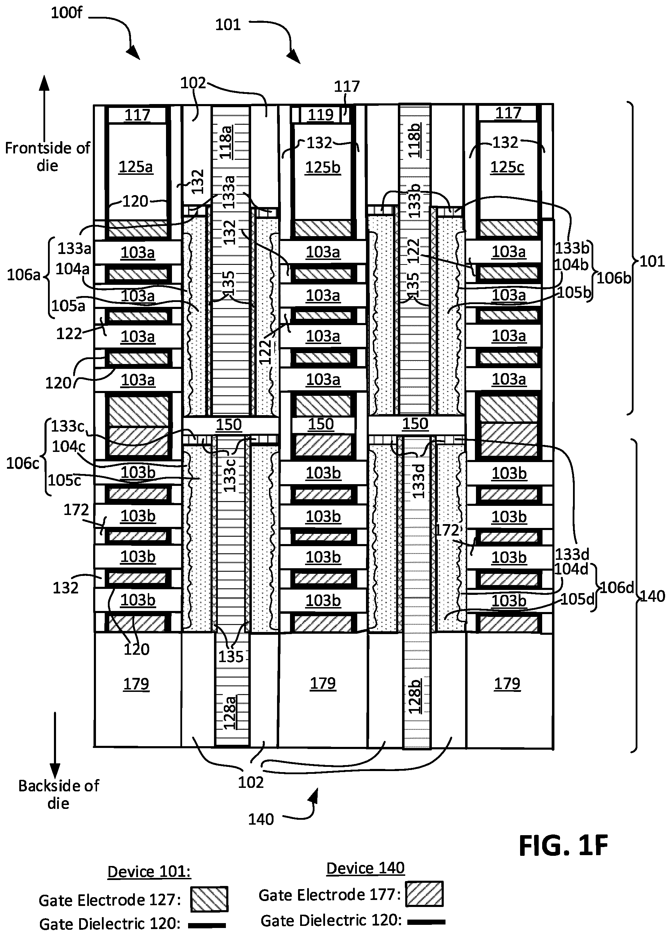

**Fig. 1F** illustrates an integrated circuit structure that is similar to the integrated circuit structure of Fig. 1A, but without backside gate contacts for the lower device, in accordance with an embodiment of the present disclosure.

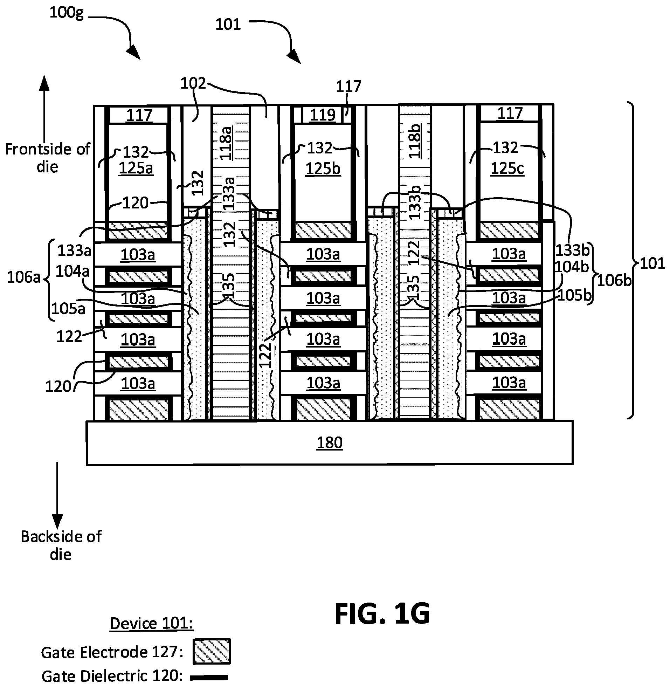

**Fig. 1G** illustrates a cross-section view of an integrated circuit structure 100g including a device comprising (i) a first source contact and a first drain contact, (ii) remnants of a first core region of a source region of the device, and (iii) remnants of a second core region of a drain region of the device, wherein at least a central section of a core region of a source or drain region is removed during formation of a corresponding source or drain contact, leaving behind the remnants of the core region, in accordance with an embodiment of the present disclosure.

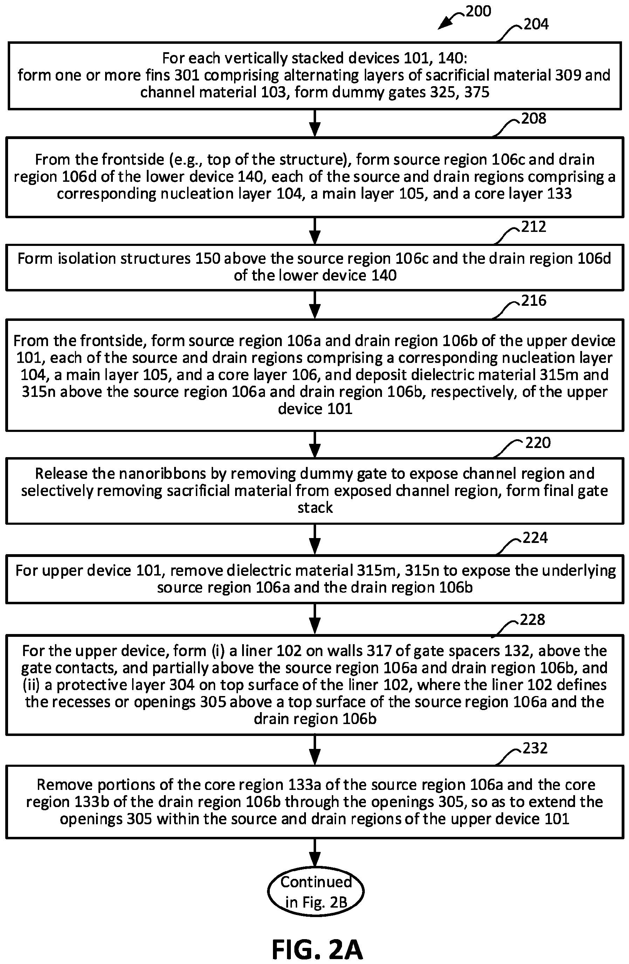

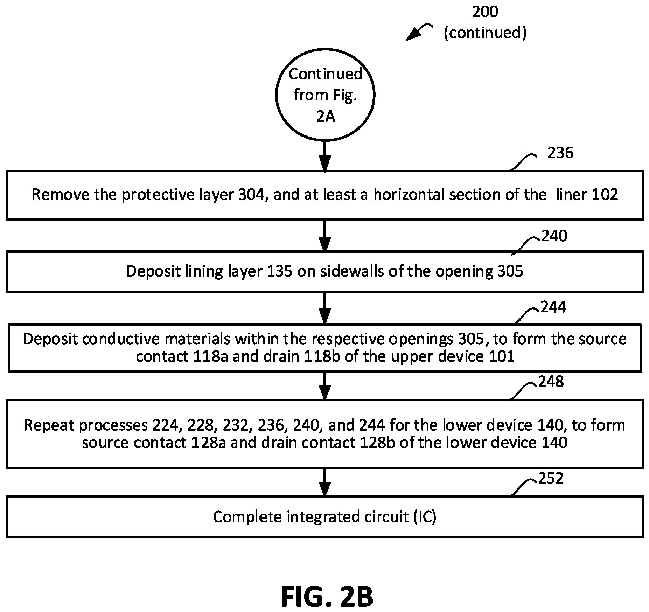

**Figs. 2A** **and** **2B** illustrate a flowchart depicting a method of forming the example nanoribbon semiconductor structure of Fig. 1A, in accordance with an embodiment of the present disclosure.

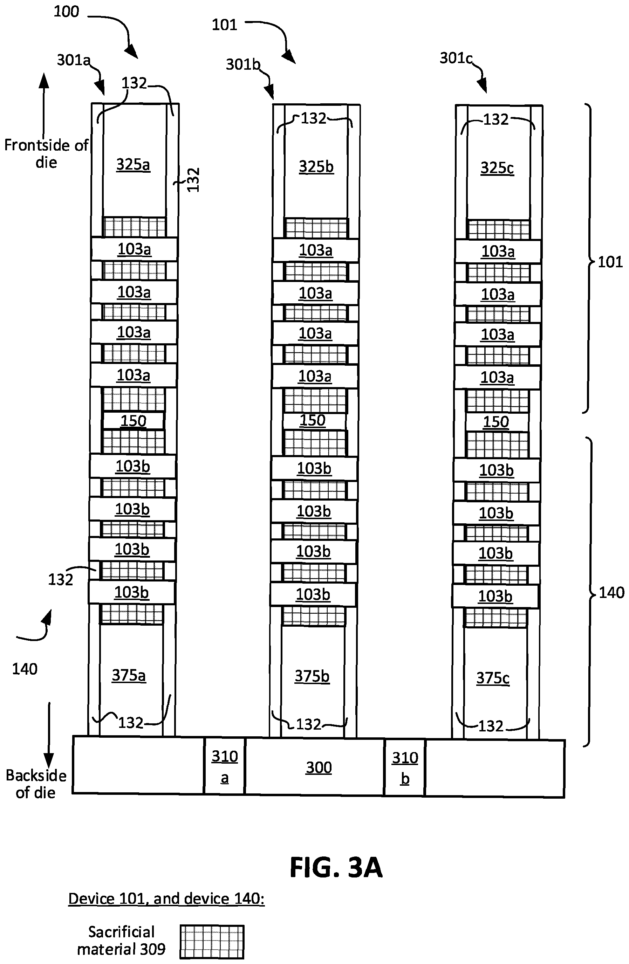

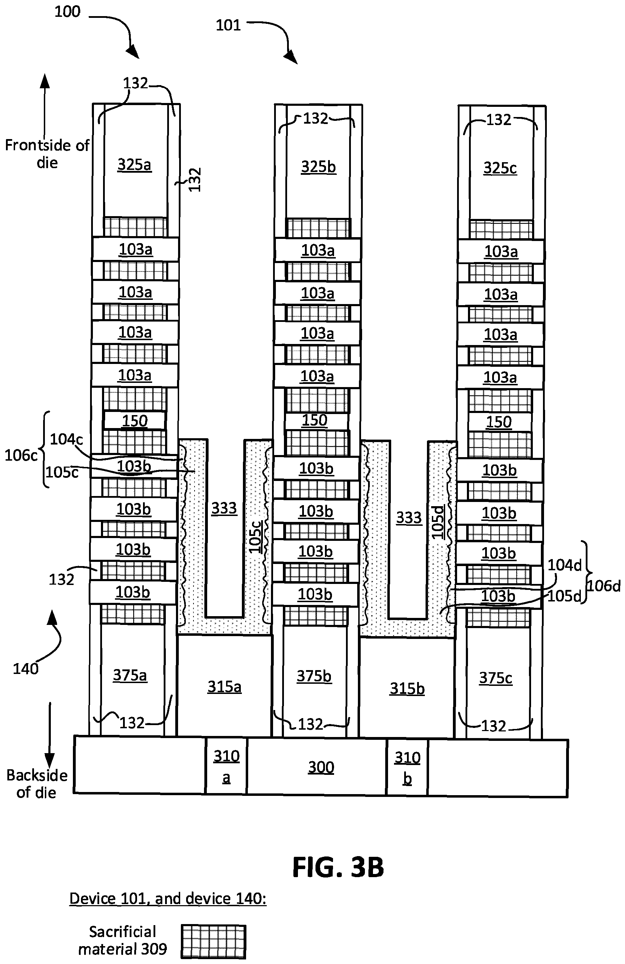

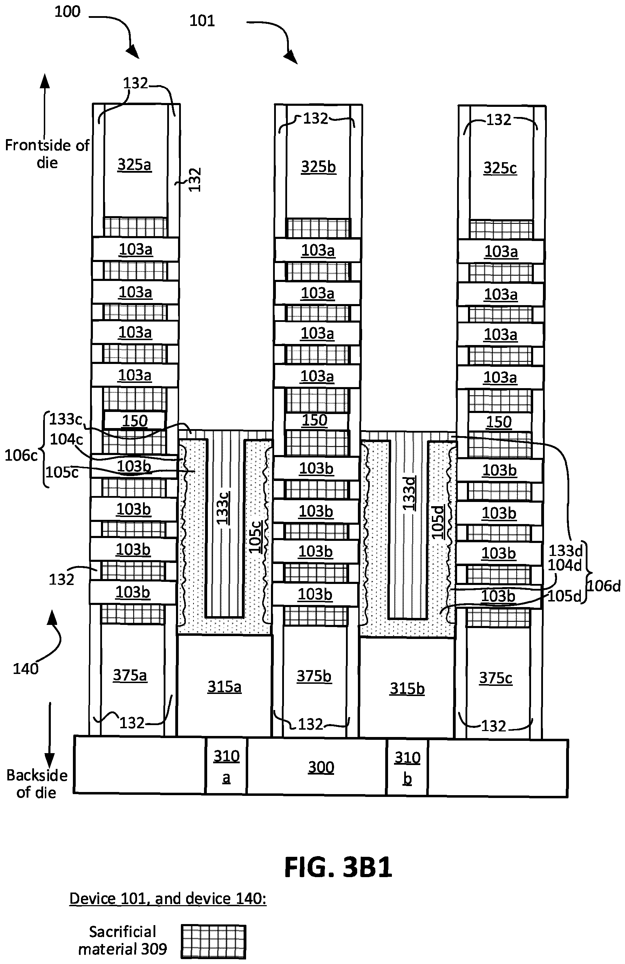

**Figs. 3A****,** **3B**, 3B1, 3C, 3D, 3D1, 3E, 3F, 3G, 3H, 3I, 3I1, 3J, 3J1, 3K, 3L, 3M, and 3N collectively illustrate cross-sectional views of an example semiconductor structure in various stages of processing, in accordance with an embodiment of the present disclosure.

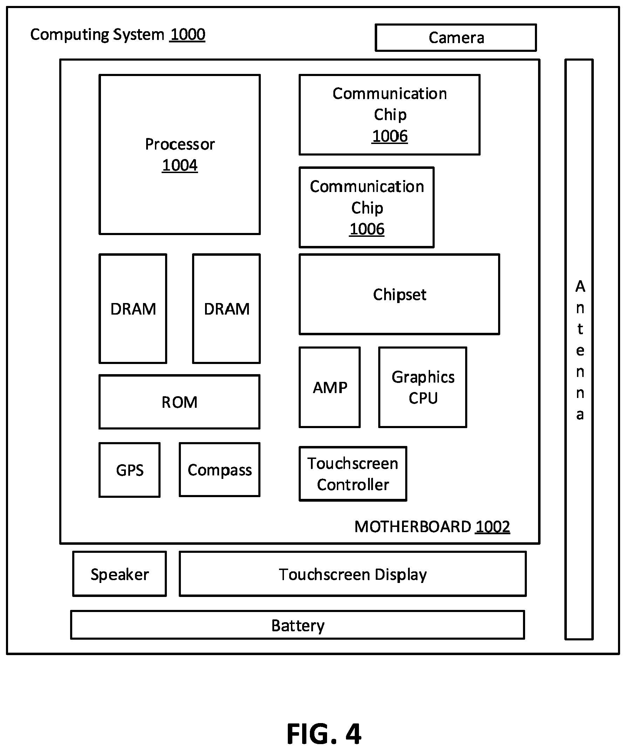

**Fig. 4** illustrates a computing system implemented with integrated circuit structures formed using the techniques disclosed herein, in accordance with some embodiments of the present disclosure.

As will be appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles, and some features may have surface topology or otherwise be non-smooth, given real world limitations of the processing equipment and techniques used. Likewise, while the thickness of a given first layer may appear to be similar in thickness to a second layer, in actuality that first layer may be much thinner or thicker than the second layer; same goes for other layer or feature dimensions.

### DETAILED DESCRIPTION

A three-dimensional (3D) contact architecture for source and drain contacts is disclosed. In an example, such a contact is formed by removing a sacrificial core region of a source (or drain) region, where the sacrificial core region is etch-selective to a main region of the source (or drain) region. Remnants of the sacrificial core region may remain in the source (or drain) region. Such techniques can be applied for forming source and drain contacts in any appropriate transistor devices, and are also suitable for forming source and drain contacts in a vertical stack of transistor devices. For example, the source and drain contacts of an upper device of the vertical stack can be formed from a frontside of the die, and the source and drain contacts of a lower device of the vertical stack can be formed from a backside of the die.

In one embodiment, an integrated circuit structure comprises a device including (i) a source region, (ii) a drain region, (iii) one or more bodies comprising semiconductor material laterally extending from the source region to the drain region, and (iv) a source contact comprising a conductive material coupled to the source region. In an example, the source region comprises (i) a first region, and (ii) a second region compositionally different from and above the first region, wherein the source contact extends through the second region and extends within the first region. In an example, a doping concentration level of a dopant (e.g., an n-type dopant, where the device is a n-channel metal-oxide-semiconductor (NMOS) device) within the first region is different from a doping concentration level of the dopant within the second region. In an example, the device further comprises dielectric material above the source region, such that the source contact extends through the dielectric material, to reach the source region, where at least a section of the second region is between a bottom surface of the dielectric material and a top surface of the first region. In an example, the device is an upper device of a stack of vertical devices, the source region is a first source region, the drain region is a first drain region, the one or more bodies are first one or more bodies, the source contact is a first source contact, and wherein the integrated circuit further comprises a lower device below the first device. In an example, the lower device comprises (i) a second source region, (ii) a second drain region, and (iii) one or more second bodies comprising semiconductor material laterally extending from the second source region to the second drain region, and (iv) a second source contact comprising a conductive material coupled to the second source region. In an example, the second source region comprises (i) a third region, and (ii) a fourth region compositionally different from and above the first region, wherein the second source contact extends through the third region to contact the fourth region. In some such cases, the contact extends into the fourth region. In some other such cases, the contact abuts a surface of the fourth region but does not extend into the fourth region. In an example, each of the third and fourth source regions comprise silicon and germanium, with a concentration of germanium within the fourth region being higher than a concentration of germanium within the third region.

In another embodiment, an integrated circuit structure comprises a first device stacked above a second device. In an example, the first device comprises a first source region that includes (i) a first region, and (ii) a second region above the first region. In an example, a doping concentration level of a dopant within the second region is at least 20% more than a doping concentration level of the dopant within the first region. In an example, the second device comprises a second source region that includes (i) a third region, and (ii) a fourth region above the third region. In an example, each of the third and fourth source regions comprise silicon and germanium, with a concentration of germanium within the fourth region being higher than a concentration of germanium within the third region by at least 10%. In an example, the first device is a NMOS device, and the second device is a PMOS device.

In yet another embodiment, a method of forming a source or drain contact of a transistor device comprises forming (e.g., growing epitaxially) a first portion of a source or drain region, the first portion defining a recess that extends at least in part within the first portion of the source or drain region. In an example, the method further comprises forming a second portion of the source or drain region, the second portion at least in part within the recess. In an example, the second portion is compositionally different from, and etch-selective with respect to, the first portion. In an example, the method further comprises removing at least a section of the second portion of the source or drain region, to form an opening extending within the first portion of the source or drain region. In an example, the method further comprises forming the source or drain contact that is at least in part within the opening extending within the first portion of the source or drain region. Numerous configurations and variations will be apparent in light of this disclosure.

### General Overview

Integrated circuitry continues to scale to smaller feature dimensions and higher transistor densities. As a result, a gate pitch, as well as a pitch for source and drain contacts, continue to reduce. With such tight pitch, it is desirable to maintain the contact area of source or drain contacts as large and uniform as possible, to maintain reasonable external resistance between the source or drain contact and the corresponding source or drain region.

Accordingly, techniques are provided herein to form an IC that includes transistor devices comprising source and drain contacts that extend into a given diffusion region (such as source region or drain region) so as to provide a three-dimensional (3D) contact structure. The so-formed contact structures may be relatively large and uniform. For example, to provide relatively large source and drain contacts, the source and drain contacts are embedded within the source and drain regions, respectively. For example, a source contact extends within a corresponding source region, and a drain contact extends within a corresponding drain region, thereby making the contact area between the source contact and the source region (or between the drain contact and the drain region) relatively large. Such contacts that extend within a given diffusion region (source or drain region) are referred to herein as three-dimensional (3D) contacts. Also, the multilayer structure of the diffusion region is such that the contact trench etch process yields relatively consistent contact trench depths across a given die or wafer.

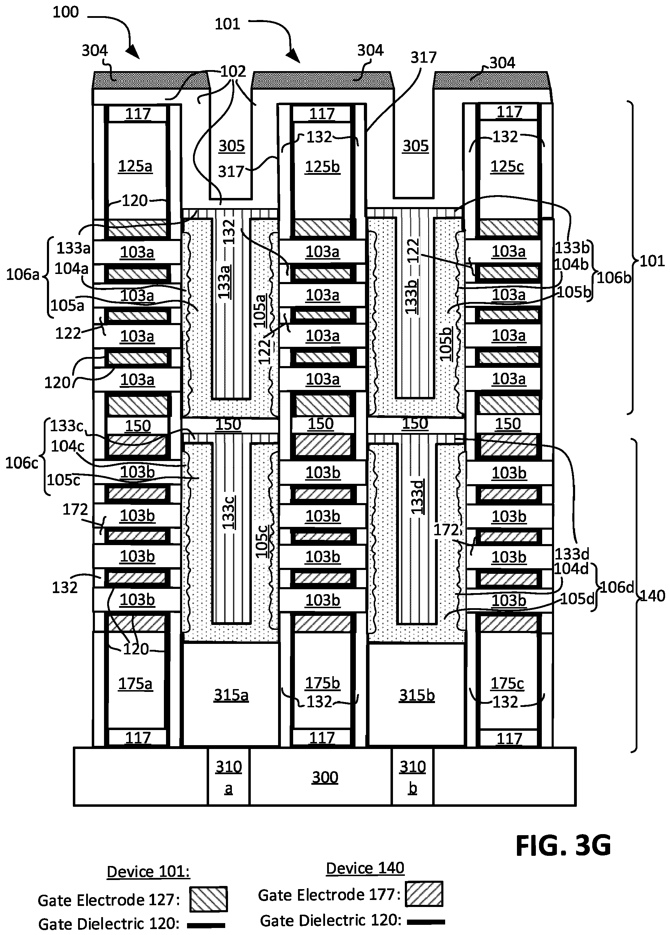

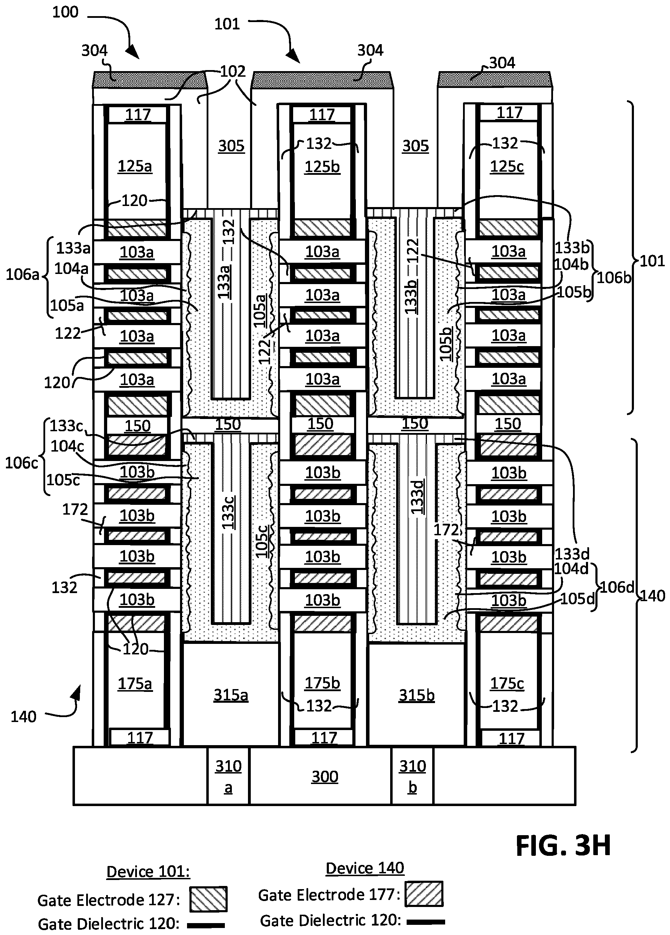

In an example, to form such uniform 3D source and drain contacts, the source and drain regions of a device are formed to have a multi-layer structure. Discussed herein below are techniques for forming a uniform 3D source contact, and such techniques can be applied to form a drain contact as well. For example, when forming a source region of a device, a nucleation layer of the source region is initially formed. Subsequently, a main region of the source region is formed, e.g., formed epitaxially. In an example, the epitaxial growth of the main region may be timed to not merge, such that there is a recess extending within the epitaxial growth of the main region (e.g., see Fig. 3B). Subsequently (e.g., see Fig. 3B1), a core region of the source region is formed (e.g., also epitaxially grown) within the recess of the main region. A top portion of the core region may be above the top surface of the main region. In an example, the core region and the main region of the source region are compositionally different, such that the core region is etch selective to the main region (e.g., an etch process to etch the core region does not substantially etch the main region). For example, for a PMOS device comprising silicon germanium (SiGe) within the source region, a concentration of Ge in the core region may be different (e.g., higher) than a concentration of Ge in the main region, resulting in the etch selectivity between the core and main regions. In another example, for a NMOS device comprising a n-type dopant (e.g., phosphorous) within the source region, a concentration of the dopant in the core region may be different (e.g., higher) than a concentration of the dopant in the main region, resulting in the etch selectivity between the core and main regions. Other example compositional differences between the core and main regions, to achieve the etch selectivity, may also be possible. Once the source region comprising the nucleation layer, the main region, and the core region are formed, channel region of the device (where the channel region may comprise nanoribbons, or another type of GAA channel region, such as nanowires or nanosheets) are released (e.g. by removing a dummy gate stack and sacrificial material), and a final gate stack is completed. Subsequently, when forming the source contact, the source trench is opened, and a liner layer is formed on walls of upper gate spacers, where the liner layer defines a recess or opening above the top surface of the source region (formation of the liner layer is discussed with respect to Figs. 3G and 3H herein in turn). A section of the core region, which extends within the main region, is removed (e.g., etched) through the opening defined by the liner layer. As discussed, the etch process is selective to the liner layer and the main region, and does not substantially etch the liner layer and the main region. Note that although the core region extending within the main region is removed, remnants of the top portion of the core region may remain between the liner layer and the main region. Subsequently, the recess within the main region (e.g., formed as a result of removing the core region) is filed with conductive material, to form the source contact. Thus, the source contact now occupies the space that was previously occupied by at least a section of the core region, resulting in a uniform 3D contact profile for the source contact. The drain contact may also be formed in a similar manner. As discussed, remnants of the core region may remain between the liner layer and the main region within the source region, and remnants of the core region may also remain between the liner layer and the main region within the drain region.

In an example, the above discussed techniques for forming a source and drain contact may also be applicable for more than one device that are stacked in a vertical stack. For example, assume that an upper device is to be stacked above a lower device. In an example, one of the upper and lower devices is a PMOS device, and the other of the upper and lower devices is an NMOS device, and the two devices are coupled in a complementary metal oxide semiconductor (CMOS) architecture. In an example, one or both the upper and lower devices may be GAA devices. Note that an example of the channel region in a GAA device includes nanoribbons. As will be appreciated in light of this disclosure, reference to nanoribbons as channel regions is also intended to include other gate-all-around or multi-gate channel regions, such as nanowires, nanosheets, and other such semiconductor bodies around which a gate structure can wrap. To this end, the use of a specific channel region configuration (e.g., nanoribbon) is not intended to limit the present description to that specific channel configuration. Rather, the techniques provided herein can benefit any number of channel configurations, whether those bodies be nanowires, nanoribbons, nanosheets or some other body around which a gate structure can at least partially wrap (such as the semiconductor bodies of a forksheet device or a fin-based device).

Continuing with the above discussion regarding the vertical stack of devices, the below discussion pertains to forming uniform 3D source contacts for the upper and lower devices, and such techniques can be applied to form the drain contacts for the upper and lower devices as well. Note that the upper device is near a frontside of the die, and the lower device is near a backside of the die. When forming the source regions of the upper and lower devices, the source region of the lower device is formed first from the frontside. The source region of the lower device comprises a corresponding nucleation layer, a corresponding main region, and a corresponding core region that is at least in part embedded within the main region, as discussed herein above. Then the source region of the upper device is formed, where the source region of the upper device similarly comprises a corresponding nucleation layer, a corresponding main region, and a corresponding core region that is at least in part embedded within the main region. As discussed herein above, for each of the upper and lower devices, the core region and the corresponding main region are compositionally different and hence, etch selective with respect to each other. In an example, an isolation structure comprising non-conductive material may be between the source regions of the upper and lower devices.

Once the source regions of the upper and lower devices are formed, channel region of the upper and lower devices (where the channel region may comprise nanoribbons, or another type of GAA channel region, such as nanowires or nanosheets) are released (e.g. by removing a dummy gate stack and sacrificial material), and a final gate stack is completed. Subsequently, the source contact (and similarly the drain contact) of the upper device is initially formed from a frontside or top of the device stack, followed by formation of the source contact (and similarly the drain contact) of the lower device from a backside of the device stack. The formation of the source contact (and drain contact as well) of the upper device is similar to the source contact formation processes discussed herein above. Note that as previously discussed herein, although the core region of the source region of the upper device is removed in part, remnants of the core region may remain between the liner layer and the main region of the source region of the upper device. Once the source and drain contacts of the upper device are formed, the structure is flipped upside-down (e.g., while being supported by a carrier wafer attached to its frontside), and the source and drain contacts of the lower device are processed from the backside, e.g., in a similar manner as discussed herein above. However, note that for the lower device, remnants of the core region may remain between the main region of the source (and drain) region of the lower device and the isolation structure, e.g., as discussed in further detail with respect to Fig. 1A.

The use of "group IV semiconductor material" (or "group IV material" or generally, "IV") herein includes at least one group IV element (e.g., silicon, germanium, carbon, tin), such as silicon (Si), germanium (Ge), silicon-germanium (SiGe), and so forth. The use of "group III-V semiconductor material" (or "group III-V material" or generally, "III-V") herein includes at least one group III element (e.g., aluminum, gallium, indium) and at least one group V element (e.g., nitrogen, phosphorus, arsenic, antimony, bismuth), such as gallium arsenide (GaAs), indium gallium arsenide (InGaAs), indium aluminum arsenide (InAlAs), gallium phosphide (GaP), gallium antimonide (GaSb), indium phosphide (InP), gallium nitride (GaN), and so forth. Note that group III may also be known as the boron group or IUPAC group 13, group IV may also be known as the carbon group or IUPAC group 14, and group V may also be known as the nitrogen family or IUPAC group 15, for example.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. In particular, in some embodiments, such tools be used to detect a vertical stack of an upper device and a lower device, with each of the source region and the drain region of the upper device comprising (i) a corresponding main region, and (ii) a corresponding core region above the main region, and between the main region and a dielectric material layer, where the main region and the core region compositionally different. Also, each of the source region and the drain region of the lower device comprises (i) a corresponding main region, and (ii) a corresponding core region above the main region, and between the main region and an isolation structure (where the isolation structure separated the upper and lower devices), where the main region and the compositionally different. In an example, the upper device is one of a PMOS device or an NMOS device, and the lower device is another of the PMOS device or the NMOS device. Such tools may also detect that a doping concentration within the core region is different (e.g., higher) than a doping concentration within the main region of the source and drain regions of the NMOS device. Such tools may also detect that a concentration of germanium within the core region is different (e.g., higher) than a concentration of germanium within the main region of the source and drain regions of the NMOS device. Numerous configurations and variations will be apparent in light of this disclosure.

### Architecture

**Fig. 1A** illustrates a cross-section view of an integrated circuit structure 100 (also referred to herein as "structure 100") including a vertically stacked architecture having an upper device 101 above a lower device 140, wherein the integrated circuit structure 100 comprises (i) a first source contact 118a and a first drain contact 118b of the upper device 101, (ii) a second source contact 128a and a second drain contact 128b of the lower device 140, (iii) remnants of a first core region 133a of a source region 106a of the upper device 101, (iv) remnants of a second core region 133b of a drain region 106b of the upper device 101, (iii) remnants of a third core region 133c of a source region 106c of the lower device 140, (iv) remnants of a fourth core region 133d of a drain region 106d of the lower device 140, wherein at least a central section of a core region of a source or drain region is removed during formation of a corresponding source or drain contact, leaving behind the remnants of the core region, in accordance with an embodiment of the present disclosure.

As can be seen, the cross-section of Fig. 1 is taken parallel to, and through, the fin structure, such that the channel, source, and drain regions are shown. This particular cross-section includes three channel regions along with a source region and a drain region for each device, but any number of channel regions and corresponding source and drain regions can be included, as will be appreciated. Further note that all devices shown in this example are contacted, but other examples may include dummy devices or devices that are not connected into the overall circuit. The semiconductor bodies 103a and 103b included in the channel regions of the devices 101 and 140, respectively, can vary in form, but in this example embodiment are in the form of nanoribbons. In particular, the channel regions of the upper device 101 in this example case include a first set of four nanoribbons 103a, and the channel regions of the lower device 140 include a second set of four nanoribbons 103b. Other examples may include fewer nanoribbons per channel region (e.g., one or two), or more nanoribbons per channel region (e.g., five or six). Still other embodiments may include other channel configurations, such as one or more nanowires or a fin or other semiconductor body, including both planar and nonplanar topologies. To this end, the present disclosure is not intended to be limited to any particular channel configuration or topology; rather the techniques provided herein can be used in any transistor architecture that uses complementary type of adjacent transistors.

The device configuration includes vertically stacked devices 101 and 140, where the upper device 101 is above the lower device 140. In the example of Fig. 1A, the upper device 101 includes the source region 106a and the drain region 106b, each adjacent to a gated channel region on either side. Other embodiments may not have gated channel regions to each side, such as the example case where only the channel region between source region 106a and drain region 106b is present. The lower device 140 includes the source region 106c and the drain region 106d, each adjacent to a gated channel region on either side. Other embodiments may not have gated channel regions to each side, such as the example case where only the channel region between source region 106c and drain region 106d is present.

Note that in an example, the location of the source and drain regions in one or both devices may be interchanged, and the source and drain regions are generically referred to herein as a diffusion region. Thus, a diffusion region may refer to either of a source region or a drain region. The source and drain regions will be discussed in further detail herein in turn.

In one embodiment, each of gate structures 122 of the device 101 wraps around each of the nanoribbons 103a in the corresponding channel region. Gate spacers 132 isolates the gate structures 122 from contacting the source region 106a and the drain region 106b. In other embodiments, there may be other insulator layers (e.g., interlayer dielectric) that prevent such contact, whether in addition to the gate spaces 132, or in place of the gate spacers 132. In an example, frontside conductive gate contacts 125a, 125b, and 125c provide contacts to respective three gate structures 122 of the device 101. Dielectric material 117 is above individual gate contacts 125a, 125b, and 125c. In this example, dielectric material 117 above gate contacts 125a, 125c has not been opened for purpose of coupling contacts 125a, 125c to an interconnect feature. In contrast, the dielectric material 117 over gate contact 125b has been opened, such that conductive via 119 extends through the dielectric material 117 and contacts the corresponding gate contact 125b. A frontside interconnect feature can then be contacted to via 119.

In one embodiment, each of gate structures 172 of the device 140 wraps around each of the nanoribbons 103b in the corresponding channel region. Gate spacers 132 isolates the gate structures 172 from contacting the source region 106c and the drain region 106d. In other embodiments, there may be other insulator layers (e.g., interlayer dielectric) that prevent such contact, whether in addition to the gate spaces 132, or in place of the gate spacers 132. In an example, backside conductive gate contacts 175a, 175b, and 175c provide contacts to respective three gate structures 172 of the device 101. In some embodiments, lower and/or upper interconnect structures may be present, to further route signals to and/or from the gate contacts 125, 175. Any number of suitable interconnects schemes can be used. Dielectric material 117 is below individual gate contacts 175a, 175b, and 175c. In an example, the dielectric material 117 below one or more of the gate contacts, such as gate contact 175b, may be opened, such that a conductive via 119 extends through the dielectric material 117 and contacts the corresponding gate contact 175b. A backside interconnect feature can then be contacted to via 119.

Each of gate structures 122, 172 can be formed via gate-first or gate-last processing, and may include any number of suitable gate materials and configurations. In an embodiment, each of the gate structures 122, 172 includes a corresponding gate electrode and a gate dielectric 120 between the gate electrode and the corresponding nanoribbons 10. In one example the gate spacers 132 may be considered part of the gate structure, whereas in another example the gate spacers 132 may be considered external to the gate structure.

The gate structure 122 of the upper device 101 comprises a corresponding gate electrode 127 and corresponding dielectric material 120. The gate structure 172 of the lower device 140 comprises a corresponding gate electrode 177 and corresponding dielectric material 120. The gate dielectric material 120 (shown with thick bolded lines) warps around middle section of individual nanoribbons 103 (note that end sections of individual nanoribbons 103 are wrapped around by the gate spacers 132). The gate dielectric material 120 is between individual nanoribbons 103 and corresponding gate electrode, as illustrated. In an example, due to conformal deposition of the gate dielectric material 120, the gate dielectric material 120 may also be on inner sidewalls of the gate spacers 132, as illustrated.

The gate dielectric 120 may include a single material layer or multiple stacked material layers. The gate dielectric may include, for example, any suitable oxide (such as silicon dioxide), high-k dielectric material, and/or any other suitable material as will be apparent in light of this disclosure. Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. The high-k dielectric material (e.g., hafnium oxide) may be doped with an element to affect the threshold voltage of the given semiconductor device. According to some embodiments, the doping element used in gate dielectric 120 is lanthanum. In some embodiments, the gate dielectric can be annealed to improve its quality when high-k dielectric material is used. In some embodiments, the gate dielectric 120 includes a first layer (e.g., native oxide of nanoribbons, such as silicon dioxide or germanium oxide or SiGe-oxide) on the nanoribbons, and a second layer of high-k dielectric (e.g., hafnium oxide) on the first layer.

In an example, the gate electrode 127 of the device 101 and the gate electrode 177 of the device 140 may include any sufficiently conductive material, such as a metal, metal alloy, or doped polysilicon. The gate electrodes may include a wide range of materials, such as polysilicon or various suitable metals or metal alloys, such as aluminum, tungsten, titanium, tantalum, copper, cobalt, molybdenum, titanium nitride, or tantalum nitride, for example.

In one embodiment, one or more work function materials (not illustrated in Fig. 1) may be included around the nanoribbons 103. Note that work function materials are called out separately, but may be considered to be part of the gate electrodes. In this manner, a gate electrode may include multiple layers or components, including one or more work function materials, gate fill material, capping or resistance-reducing material, to name a few examples. In some embodiments, a p-channel device may include a work function metal having titanium, and an n-channel device may include a work function metal having tungsten or aluminum, although other material and combination may also be possible. In some other embodiments, the work function metal may be absent around one or more nanoribbons 103. In still other embodiments, there may be insufficient room for any gate fill material, after deposition of work function material (a given gate electrode may be all work function material and no fill material). Numerous gate structure configurations can be used along with the techniques provided herein, and the present disclosure is not intended to be limited to any particular such configurations.

The semiconductor bodies 103a, 103b, which in this case are nanoribbons, can be any number of semiconductor materials as well, such as group IV material (e.g., silicon, germanium, or SiGe) or group III-V materials (e.g., indium gallium arsenide). In other embodiments, the semiconductor bodies 103 may be fins on which the corresponding gate structures are formed to provide double-gate or tri-gate configurations (as opposed to gate-all-around configurations with nanoribbons or wires). The semiconductor bodies 103 may be lightly doped, or undoped, and may be shaped or sculpted during the gate formation process, according to some embodiments. In some cases, semiconductor bodies 103 may be a multilayer structure, such as a SiGe body cladded with germanium, or a silicon body cladded with SiGe. Any number of channel configurations can be used.

Referring to the left most-set of nanoribbons 103a of the upper device 101 (also referred to herein as left-upper nanoribbons 103a) and the left most-set of nanoribbons 103b of the lower device 140 (also referred to herein as left-lower nanoribbons 103b), the left-upper nanoribbons 103a and the left-lower nanoribbons 103b can be formed form the same fin structure. Similarly, other vertically adjacent sets of nanoribbons of the two devices 101, 40 can be formed from the same fin structure. Note that the top and bottom channel regions of the fin structure may be compositionally and/or structurally configured the same or differently, with respect to shape and/or semiconductor materials, and may further include fin-based channel regions, nanowire-based channel regions, or nanoribbon-based channel regions. For instance, the lower portion of the fin structure comprises, for example, SiGe or germanium suitable for PMOS devices interleaved with sacrificial material, and the upper portion of the fin structure comprise a group III-V semiconductor material such as indium gallium arsenide, indium arsenide, or gallium antimonide suitable for NMOS devices interleaved with sacrificial material. In another example embodiment, the lower channel region is configured with a first fin portion of the fin structure comprising a first semiconductor material (e.g., SiGe), and the upper channel region is configured with a second fin portion of the fin structure comprising a second semiconductor material (e.g., silicon) that is compositionally different from the first semiconductor material.

As can further be seen in Fig. 1A, non-conductive isolation structure 150 isolates the upper device 101 from the lower device 140. For example, the isolation structure 150 prevents the gate structures 122 of the upper device 101 from contacting the gate structures 172 of the lower device 140. In an example, the isolation structure 150 is between upper gate electrode 127 of the upper device 101 and the lower gate electrode 177 of the lower device 140, as illustrated in Fig. 1A. However, in another example, the isolation structure 150 may be absent between an upper gate electrode 127 and a corresponding lower gate electrode 177, such that the upper and lower gate electrodes are electrically shorted, e.g., depending on a design of a circuit that includes the devices 101, 140.

In an example, the isolation structure 150 is also between the source region 106a of the upper device and the source region 106c of the lower device 140, and electrically isolates the two source regions. Similarly, the isolation structure 150 is also between the drain region 106b of the upper device and the drain region 106d of the lower device 140, and electrically isolates the two drain regions. In an example, the isolation structure 150 comprises dielectric material, e.g., one or more appropriate oxides, nitrides, carbides, oxynitrides, oxycarbides, and oxycarbonitrides. In some example embodiments, isolation structure 150 includes silicon, and one or more of oxygen, carbon, and nitrogen (e.g., silicon oxycarbide, or silicon oxycarbonitride). group IV material (e.g., silicon, germanium, or SiGe)

As illustrated in Fig. 1A, for the device 101, a source contact 118a extends within the source region 106a, and a drain contact 118a extends within the drain region 106a. Similarly, for the device 140, a source contact 128a extends within the source region 106c, and a drain contact 128b extends within the drain region 106c. In an example, the source contact 118a, the drain contact 118b, the source contact 128a, and the drain contact 128b comprise appropriate conductive material, such as one or more metals or an alloy thereof. In an example, the source or drain contacts may include conductive material that are similar to (or different from) the conductive material of the gate electrodes 127, 177 and/or the gate contacts 125, 175. In an example, the source contact 118a may fully extend within and extend through the source region 106a, such that the source contact 118a reaches and is in contact with isolation structure 150 between the source regions 106a and 106c. For example, a bottom surface of the source contact 118a and a bottom surface of the source region 106a may be coplanar. Similarly, in an example, the drain contact 118b may fully extend within and extend through the drain region 106b, such that the drain contact 118b reaches and is in contact with isolation structure 150 between the drain regions 106b and 106d. For example, a bottom surface of the drain contact 118b and a bottom surface of the drain region 106b may be coplanar.

In an example, the source contact 128a may fully extend within and extend through the source region 106c, such that the source contact 128a reaches and is in contact with isolation structure 150 between the source regions 106a and 106c. For example, a bottom surface of the source contact 128a and a bottom surface of the source region 106c may be coplanar. Similarly, in an example, the drain contact 128b may fully extend within and extend through the drain region 106d, such that the drain contact 128b reaches and is in contact with isolation structure 150 between the drain regions 106b and 106d. For example, a bottom surface of the drain contact 128b and a bottom surface of the drain region 106d may be coplanar.

In an example, a conductive lining layer 135 is between a source or drain contact and a corresponding source or drain region. For example, the conductive lining layer 135 is between the source contact 118a and the source region 106a, the conductive lining layer 135 is between the drain contact 118b and the drain region 106b, the conductive lining layer 135 is between the source contact 128a and the source region 106c, and the conductive lining layer 135 is between the drain contact 128b and the drain region 106d, as illustrated in Fig. 1A. In an example, the lining layer 135 is part of the corresponding source or drain region. In an example, the conductive lining layer 135 is representative of one or more silicide layer(s), germanide layer(s), and/or adhesive layer(s) between the conductive source or drain metal contact and the adjacent source or drain region. In an example, the lining layer 135 reduces contact resistance of the source and drain contacts.

In the example of Fig. 1A, in the upper device 101, a liner layer 102 is between a gate spacer 132 and an upper portion of a source or drain contact. For example, in the upper device 101, the liner layer 102 is between the gate spacer 132 and an upper portion of the source contact 118a, where a lower portion of the source contact 118a extends within the source region 106a. Similarly, in the device 101, the liner layer 102 is also between the gate spacer 132 and an upper portion of the drain contact 118b, where a lower portion of the drain contact 118b extends within the drain region 106b.

Similarly, in the lower device 140, the liner layer 102 is between the gate spacer 132 and a lower portion of the source contact 128a, where an upper portion of the source contact 128a extends within the source region 106c. Similarly, in the lower device 140, the liner layer 102 is also between the gate spacer 132 and a lower portion of the drain contact 128b, where an upper portion of the drain contact 128b extends within the drain region 106d. In an example, the liner layers 102 comprise an appropriate dielectric material, such as silicon nitride, or another appropriate nitride, oxide, carbide, oxycarbide, oxynitride, or oxycarbonitride.

In an example, the source region 106a of the upper device 101 comprises a nucleation region 104a, a main region 105a that may be epitaxially formed or formed otherwise, and a core region 133a. Similarly, the drain region 106b of the upper device 101 comprises a nucleation region 104b, a main region 105b that may be epitaxially formed or formed otherwise, and a core region 133b. In an example, the source region 106c of the lower device 140 comprises a nucleation region 104c, a main region 105c that may be epitaxially formed or formed otherwise, and a core region 133c. Similarly, the drain region 106d of the lower device 140 comprises a nucleation region 104c, a main region 105d that may be epitaxially formed or formed otherwise, and a core region 133d. In some examples, the nucleation regions may be absent. Numerous source and drain configurations can be used, and the present disclosure is not intended to be limited to any particular ones.

In some example embodiments, the main regions 105a, 105b, 105c, 105d (also referred to herein generally as main regions 105 in plural, or main region 105 in singular) and the core regions 133a, 133b, 133c, 136b (also referred to herein generally as core regions 133 in plural, or core region 133 in singular) are epitaxial source and drain regions that are provided after the relevant portion of the fin or fin structure was isolated and etched away or otherwise removed. In other embodiments, the main and core regions of source/drain regions may be doped portions of the fin structure or substrate, rather than epi regions. In some embodiments using an etch and replace process, the epi source and drain regions are faceted and overgrown from a trench within insulator material (e.g., shallow trench isolation, or gate spacer 132 that deposits on the sides of the fin structure in the source and drain locations), and the corresponding source or drain contact structure lands on that faceted portion. Alternatively, in other embodiments, the faceted portion of epi source and drain regions can be removed (e.g., via chemical mechanical planarization, or CMP), and the corresponding source or drain contact structure lands on that planarized portion. Example processes for formation of the main and core regions will be discussed herein in turn in further detail.

As will be discussed herein in turn (e.g., with respect to method 200 of Figs. 2A and 2B), for a source or a drain region, a core region 133 is initially formed to extend within and also above the corresponding main region 105. Subsequently, a portion of the core region 133, which at least in part extends within the corresponding main region 105, is removed (e.g., etched) and replaced with the source or drain contact. Thus, this portion of the core region 133, which is removed to be replaced by the corresponding source or drain contact, acts as a sacrificial material. After removal of this portion of the core region 133, remnants of the core region (which are also referred to simply as core region) remain of the structure 100, as illustrated in Fig. 1A.

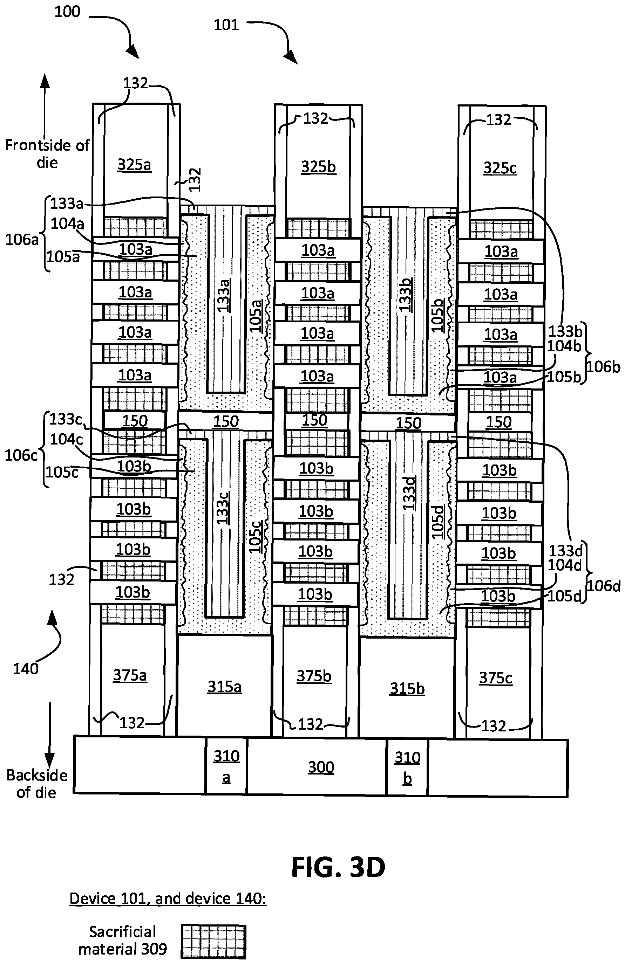

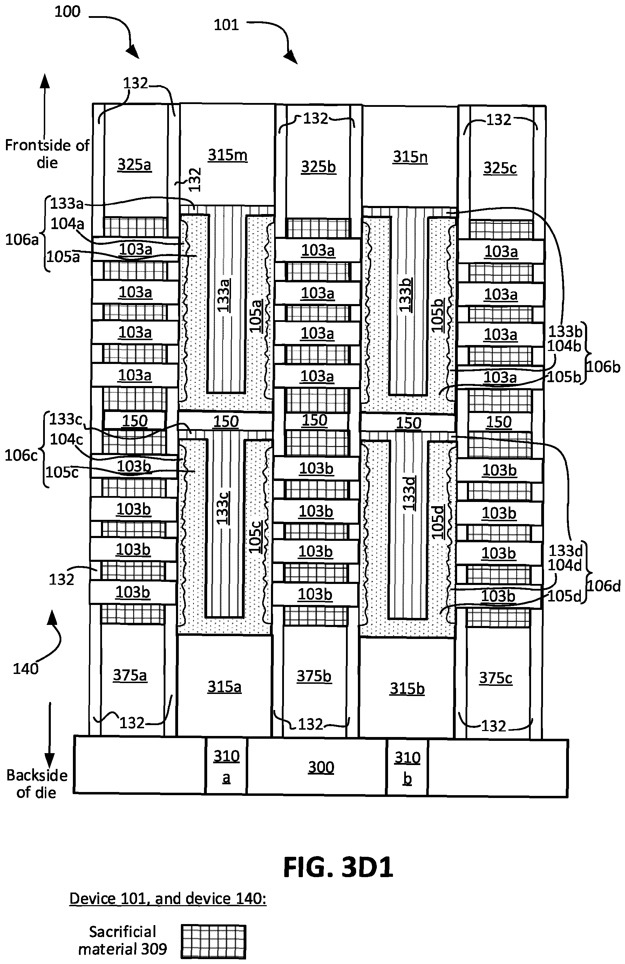

Note that the core region is termed as a "core" region, because at initial stage of formation (e.g., as illustrated in Fig. 3D), this core region 133 forms a core or central section of the corresponding source or drain region, although this central section of the core region is sacrificial in nature, and is at least in part later removed to make space for corresponding source or drain contact. In this disclosure, the core region 133 is also referred to as a central region, or a sacrificial region of a source or drain, or a peripheral region (e.g., because remnants of the core region is on periphery of the corresponding source or drain region, as illustrated in Fig. 1A).

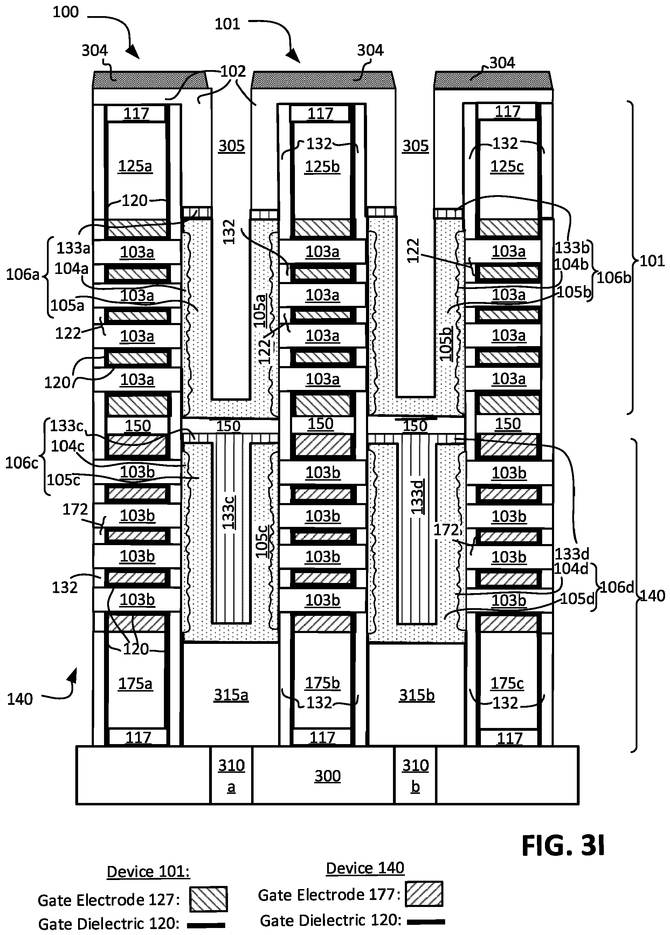

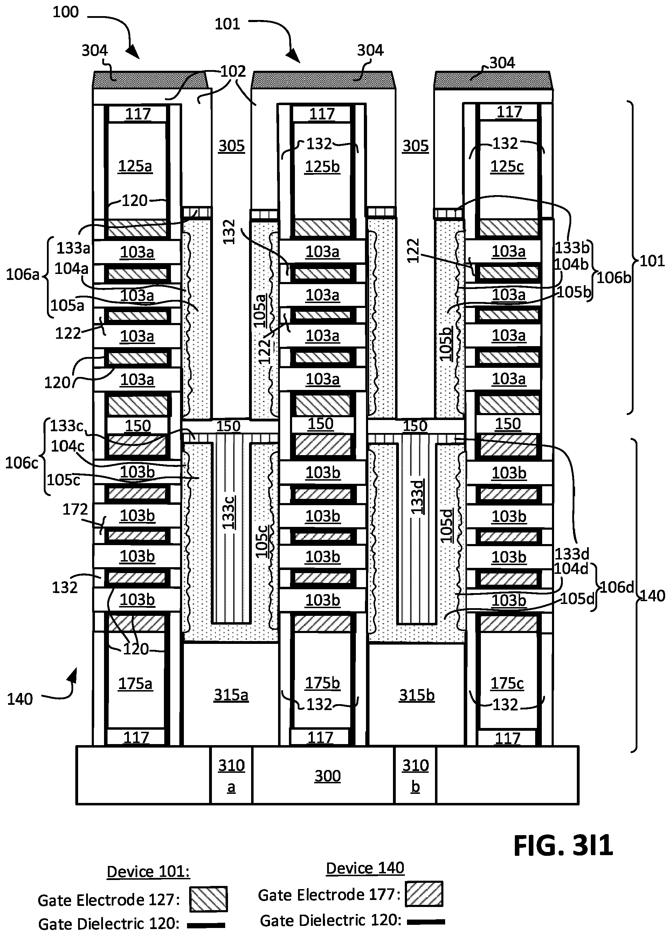

In an example, the core region 133 is etch selective with respect to the main region 105. For example, as will be discussed herein later with respect to Figs. 2A, 2B, and 3I, when the portion of the core region 133 extending within the main region 105 is etched (e.g., to make space for corresponding source or drain contact), the adjacent main region 105 is not substantially etched (or etched at a lower rate than an etch rate of the core region 133). Thus, the core region 133 can be removed or etched without substantially etching the adjacent main region, thereby making the process of forming an opening within the source or drain region (e.g., for formation of a corresponding source or drain contact) relatively easy. Accordingly, a uniform 3D source or drain contact profile for the source or drain contact can be achieved. For example, a desired source or drain contact profile can be achieved by appropriately forming the core region 133, as a section of this core region will later be replaced by the corresponding source or drain contact.

In an example, for a given source or drain region, the corresponding main region 105 is compositionally different from the corresponding core region 133, e.g., to achieve the above discussed etch selectivity between the core and main regions. For example, referring to the source region 106a of the upper device 101, the main region 105a is compositionally different from the corresponding core region 133a. Similarly, referring to the drain region 106b of the upper device 101, the main region 105b is compositionally different from the corresponding core region 133b. Similarly, referring to the source region 106c of the lower device 140, the main region 105c is compositionally different from the corresponding core region 133c. Finally, referring to the drain region 106d of the lower device 140, the main region 105d is compositionally different from the corresponding core region 133d. Compositions of the main and core regions are discussed herein in turn.

The source and drain regions, including the main regions 105 and the core regions 133, can be any suitable semiconductor material and may include any dopant scheme. In an example, in each source or drain regions, the main region 105 is more heavily doped than the corresponding nucleation region 104. In an example, source and drain regions can be PMOS source and drain regions that include, for example, group IV semiconductor materials such as silicon, germanium, SiGe, germanium tin (GeSn), SiGe alloyed with carbon (SiGe:C). Example p-type dopants include boron, gallium, indium, and aluminum. Source and drain regions can be NMOS source and drain regions that include, for example, silicon or group III-V semiconductor materials such as two or more of indium, aluminum, arsenic, phosphorus, gallium, and antimony, with some example compounds including but not limited to indium aluminum arsenide, indium arsenide phosphide, indium gallium arsenide, indium gallium arsenide phosphide, gallium antimonide, gallium aluminum antimonide, indium gallium antimonide, or indium gallium phosphide antimonide. In one specific embodiment, PMOS source and drain regions are boron-doped SiGe, and NMOS source and drain regions are phosphorus-doped silicon. In a more general sense, the source and drain regions can be any semiconductor material suitable for a given application. In some cases, the epi source and drain regions (e.g., the main regions 105) may include a multilayer structure, such as a germanium cap on a SiGe body, or a germanium body and a carbon-containing SiGe spacer or liner between the corresponding channel region and that germanium body. In any such cases, a portion of the epi source and drain regions may have a component that is graded in concentration, such as a graded germanium concentration to facilitate lattice matching, or a graded dopant concentration to facilitate low contact resistance. Any number of source and drain configurations can be used as will be appreciated, and the present disclosure is not intended to be limited to any particular such configurations.

In an example, one of the devices 101 and 140 is a PMOS device, and the other of the devices 101 and 140 is an NMOS device. In an example, the lower device 140 is a PMOS device and the upper device 101 is an NMOS device (although in another example, the lower device 140 can be an NMOS device and the upper device 101 can be a PMOS device).

In an example, in a PMOS device (such as, for example, the lower device 140), the source and drain regions comprise SiGe, e.g., boron-doped SiGe (or SiGe with one or more other appropriate dopants), although other appropriate semiconductor material and/or dopant may be used, as discussed herein above. As discussed, the core region and the source region of the PMOS device are compositionally different. In an example, in the source and/or drain region of the PMOS device, a concentration of Ge in the core region 133 is different (e.g., higher) than a concentration of Ge in the main region 105. For example, if the lower device 140 is a PMOS device, then for the source region 106c, the concentration of Ge in the core region 133c is higher than the concentration of Ge in the main region 105c; and for the drain region 106d, the concentration of Ge in the core region 133d is higher than the concentration of Ge in the main region 105d. For example, in the source or drain region of the PMOS device, the concentration of Ge in the corresponding core region 133 is higher than the concentration of Ge in the corresponding main region by at least 5%, or at least 10%, or at least 15%, or at least 20%, or at least 25%, or at least 30%, or at least 35%, or at least 40%. In an example, in the source or drain region of the PMOS device, the concentration of Ge in the SiGe of the corresponding main region 105 is at most 50 atomic percent, or at most 45 atomic percent, or at most 40 atomic percent, or at most 35 atomic percent, or at most 30 atomic percent. In an example, in the source or drain region of the PMOS device, the concentration of Ge in the SiGe of the corresponding core region 133 is at least 50 atomic percent, or at least 55 atomic percent, or at least 60 atomic percent, or at least 65 atomic percent, or at least 70 atomic percent, or at least 75 atomic percent, or at least 80 atomic percent. In an example, in the source or drain region of the PMOS device, the core region 133 and the main region 105 are elementally same (e.g., both main and core regions comprise SiGe), but with different concentrations of Ge, as discussed above. In an example, in the source or drain region of the PMOS device, the core region 133 and the main region 105 have substantially same doping level (e.g., average doping concentration is within 20% or 10% of each other), and same dopants (e.g., boron) are used in both the core region 133 and the main region 105. In an example, the compositional difference between the core region and the main region of a source or drain region of the PMOS device (e.g., difference in Ge concentration) provides the above discussed etch selectivity between the core region and the main region of the source or drain region of the PMOS device.

In an example, in an NMOS device (such as, for example, the upper device 101), the source and drain regions comprises semiconductor material, such as silicon, doped with one or more appropriate dopants, such as phosphorus or one or more appropriate n-type dopants. In an example, in the source and/or drain region of the NMOS device, a dopant concentration in the core region 133 is higher than a dopant concentration in the corresponding main region 105. For example, if the upper device 101 is an NMOS device, then for the source region 106a, the dopant concentration in the core region 133a is higher than the dopant concentration in the main region 105a; and for the drain region 106b, the dopant concentration in the core region 133b is higher than the dopant concentration in the main region 105b. As discussed, the dopant can be phosphorus and/or one or more other appropriate n-type dopant (e.g., arsenic, antimony, bismuth). For example, in the source or drain region of the NMOS device, the n-type dopant concentration in the corresponding core region 133 is higher than the n-type dopant concentration in the corresponding main region by at least 1.1x, 1.2x, 1.5x, 2x, 4x, 10x, 20x, 25x, 50x, 100x, 500x, 750x, or 1000x. In an example, in the source or drain region of the NMOS device, an average concentration of dopant impurities in the core region 133 is higher than an average concentration of dopant impurities in the main region 105 of a source or drain region of the NMOS device by at least 5%, 10%, 20%, 30%, 50%, 70%, 100%, 200%, 400%, 600%, 800%, or 1000%. In an example, a dopant concentration in the main region 105 is in the range of 1E16 to 1E24 atoms per cubic cm, and a dopant concentration in the core region 133 is higher than the dopant concentration in the main region 105, as discussed above. As also discussed, dopants include phosphorus or one or more appropriate n-type dopant dopants used in source or drain regions of NMOS devices. In an example, in the source or drain region of the NMOS device, the core region 133 and the main region 105 are elementally same (e.g., both main and core regions comprise the same semiconductor material, and/or the same dopants), but with different concentrations of the dopants, as discussed above. In an example, the compositional difference between the core region and the main region of a source or drain region of the NMOS device (e.g., difference in dopant concentration) provides the above discussed etch selectivity between the core region and the main region of the source or drain region of the NMOS device. For example, as will be discussed herein later with respect to Figs. 2A and 3I, when the portion of the core region 133 extending within the main region 105 of a source or drain region of the NMOS device is etched (e.g., to make space for corresponding source or drain contact), the adjacent main region 105 is not substantially etched (or etched at a lower rate than an etch rate of the core region 133).

Referring to the upper device 101, in the source region 106a, the core region 133a is above at least a part of an upper surface of the main region 105a. For example, the core region 133a is between the liner layer 102 and the main region 105a. As illustrated, the lining layer 135 (e.g., which may be a silicide or a germanide layer) is on side surfaces of the core region 133a, and not on top or bottom surfaces of the core region 133a. The top surface of the core region 133a is in contact with the liner layer 102, and the bottom surface of the core region 133a is in contact with the main region 105a. As illustrated, the source contact 118a extends through the core region 133a. In an example, the core region 133b of the drain region 106b also has a structure and location similar to the core region 133a of the source region 106a. In an example, the core region 133a has a vertical height in the range of 2-15 nm, in the subrange of 2-10 nm, 2-6 nm, 5-15 nm, 5-10 nm, 10-15 nm, or another appropriate subrange within the range. In an example, a vertical height of the main region 105a is at least 2x (twice), or at least 3x, or at least 4x, or at least 5x, or at least 7x, or at least 10x the vertical height of the core region 133a. In an example, the core region 133a has a horizontal width in the range of 2-15 nm, in the subrange of 2-10 nm, 2-6 nm, 5-15 nm, 5-10 nm, 10-15 nm, or another appropriate subrange within the range. The core region 133b may also have similar dimensions.

Referring to the lower device 140, in the source region 106c, the core region 133c is above at least a part of an upper surface of the main region 105c. For example, the core region 133c is between the isolation region 150 and the main region 105c. As illustrated, the lining layer 135 (e.g., which may be a silicide or a germanide layer) is on side surfaces of the core region 133c, and not on top or bottom surfaces of the core region 133c. The top surface of the core region 133c is in contact with the isolation region 150, and the bottom surface of the core region 133c is in contact with the main region 105c. As illustrated, the source contact 128a extends through the core region 133c. In an example, the core region 133d of the drain region 106d also has a structure and location similar to the core region 133c of the source region 106c. In an example, the core region 133c has a vertical height in the range of 2-15 nm, in the subrange of 2-10 nm, 2-6 nm, 5-15 nm, 5-10 nm, 10-15 nm, or another appropriate subrange within the range. In an example, a vertical height of the main region 105c is at least 2x (twice), or at least 3x, or at least 4x, or at least 5x, or at least 7x, or at least 10x the vertical height of the core region 133c. In an example, the core region 133c has a horizontal width in the range of 2-15 nm, in the subrange of 2-10 nm, 2-6 nm, 5-15 nm, 5-10 nm, 10-15 nm, or another appropriate subrange within the range. The core region 133d may also have similar dimensions.

In an example, referring to the source region 106a of the upper device 101, the main region 105a is in contact with (assuming the nucleation region 104a to be a part of the main region 105a) the adjacent nanoribbons 103a, and the main region 105a acts as a source region to the adjacent nanoribbons 103a extending from the source region 106a. The core region 133a is not in direct contact with the nanoribbons 103a, as illustrated in Fig. 1A. However, in an example, due to the proximity between the core region 133a and at least the top-most ones of the nanoribbons 103a, the core region 133a may also act as a source region to at least the top-most ones of the nanoribbons 103a. For example, the core region 133a may be considered to be an extension of the adjacent main region 105a. However, in another example, the core region 133a may be considered to be external to the source region 106a, in which case the source region 106a comprises the main region 105a and the nucleation region 104a. Note that the nanoribbons 103a extend laterally between the main region 105a of the source region 106a and the main region 105b of the drain region 106b. For example, the nanoribbons 103a extend laterally between the main region 105a of the source region 106a and the drain region 106b. However, the nanoribbons 103a are not laterally between the core region 133a of the source region 106a and the drain region 106b. Similarly, the nanoribbons 103a are not laterally between the core region 133b of the drain region 106b and the source region 106a.

Similarly, the core region 133b of the drain region 106b may act as a drain region (e.g., in addition to the main region 105b) to at least the top-most ones of the nanoribbons 103a. Similarly, the core region 133c of the source region 106c may act as a source region (e.g., in addition to the main region 105c) to at least the top-most ones of the nanoribbons 103b. Similarly, the core region 133d of the drain region 106d may act as a drain region (e.g., in addition to the main region 105d) to at least the top-most ones of the nanoribbons 103b.

**Fig. 1B** illustrates a cross-section view of an integrated circuit structure 100b (also referred to herein as "structure 1 00b") including a vertically stacked architecture having an upper device 101 above a lower device 140, wherein the integrated circuit structure 100 comprises (i) a first source contact 118a and a first drain contact 118b of the upper device 101, (ii) a second source contact 128a and a second drain contact 128b of the lower device 140, (iii) remnants of a first core region 133a of a source region 106a of the upper device 101, (iv) remnants of a second core region 133b of a drain region 106b of the upper device 101, (iii) remnants of a third core region 133c of a source region 106c of the lower device 140, (iv) remnants of a fourth core region 133d of a drain region 106d of the lower device 140, wherein at least a section of a core region of a source or drain region is removed during formation of a corresponding source or drain contact, leaving behind the remnants of the core region, wherein in the upper device 101, individual remnant of the core regions is vertically between a corresponding source or drain contact and a corresponding main region, in accordance with an embodiment of the present disclosure. The structure 100b of Fig. 1B is at least in part similar to the structure 100 of Fig. 1A, and similar components in the two structures 100 and 100b are labelled similarly. The discussion with respect to the structure 100 of Fig. 1A also applies to the structure 100b of Fig. 1B.

However, unlike the structure 100 of Fig. 1A, the liner layers 102 are absent in the structure 100b of Fig. 1B. For example, the liner layers 102 are removed (e.g., etched) and replaced by the corresponding source or drain contacts, as illustrated in Fig. 1B. Thus, for the upper device 101, now the core region 133a is between a lower surface of an upper portion of the source contact 118a and an upper surface of the main region 105a. Similarly, in the drain region 106b of the upper device 101, the core region 133b is between a lower surface of an upper portion of the drain contact 118b and an upper surface of the main region 105b. Furthermore, note that in Fig. 1A, for the upper device 101, the nucleation layer 135 is on side surfaces of the core regions 133a, 133b. In contrast, in Fig. 1B, for the upper device 101, the nucleation layer 135 is on side and top surfaces of the core regions 133a, 133b.

**Fig. 1C** illustrates a cross-section view of an integrated circuit structure 100c (also referred to herein as "structure 100c") including a vertically stacked architecture having an upper device 101 above a lower device 140, wherein the integrated circuit structure 100 comprises (i) a first source contact 118a and a first drain contact 118b of the upper device 101, (ii) a second source contact 128a and a second drain contact 128b of the lower device 140, (iii) remnants of a first core region 133a of a source region 106a of the upper device 101, (iv) remnants of a second core region 133b of a drain region 106b of the upper device 101, (iii) remnants of a third core region 133c of a source region 106c of the lower device 140, (iv) remnants of a fourth core region 133d of a drain region 106d of the lower device 140, wherein at least a section of a core region of a source or drain region is removed during formation of a corresponding source or drain contact, leaving behind the remnants of the core region, wherein a source contact 118a (or a drain contact 118b) of the upper device 101 is in contact with a source contact 128a (or a drain contact 128b) of the lower device 140, in accordance with an embodiment of the present disclosure. The structure 100c of Fig. 1C is at least in part similar to the structure 100 of Fig. 1A, and similar components in the two structures 100 and 100c are labelled similarly. The discussion with respect to the structure 100 of Fig. 1A also applies to the structure 100c of Fig. 1C.

However, unlike Fig. 1A, in the structure 100c of Fig. 1C, the source contact 118a and/or the source contact 128a punches through the isolation region 150, and is in contact with each other. In another example, instead of (or in addition to) the source contacts, the drain contact 118b and/or the drain contact 128b may punch through the isolation region 150, and may be in contact with each other. Whether the source contacts of the two devices and/or the drain contacts of the two devices would be in contact with each other (or not in contact with each other) may depend on the design of the circuit that includes the upper and lower devices 101, 140.

**Fig. 1D** illustrates a cross-section view of an integrated circuit structure 100d (also referred to herein as "structure 1 00d") including a vertically stacked architecture having an upper device 101 above a lower device 140, wherein the integrated circuit structure 100 comprises (i) a first source contact 118a and a first drain contact 118b of the upper device 101, (ii) a second source contact 128a and a second drain contact 128b of the lower device 140, (iii) remnants of a first core region 133a of a source region 106a of the upper device 101, (iv) remnants of a second core region 133b of a drain region 106b of the upper device 101, (iii) a third core region 133c of a source region 106c of the lower device 140, (iv) a fourth core region 133d of a drain region 106d of the lower device 140, wherein at least a section of the core regions of the source and drain region of the upper and lower devices 101, 140 are removed during formation of a corresponding source or drain contact, leaving behind the remnants of the core regions in the upper and lower devices 101, 140, and wherein each of the source and drain regions of the lower device 140 has a continuous core region within which the corresponding source or drain contact does not extend, in accordance with an embodiment of the present disclosure.

The structure 100d of Fig. 1D is at least in part similar to the structure 100 of Fig. 1A, and similar components in the two structures 100 and 100d are labelled similarly. The discussion with respect to the structure 100 of Fig. 1A also applies to the structure 100d of Fig. 1D.

However, unlike Fig. 1A, in the structure 100d of Fig. 1D, bottom sections of the core regions 133c and 133d are not removed during formation of the source and drain contacts 128a, 128b, respectively, for the lower device 140. Accordingly, in the lower device 140, the source contact 128a does not extend within the remnants of the core region 133c, and the drain contact 128b does not extend within the remnants of the core region 133d, as illustrated in Fig. 1D.

**Fig. 1E** illustrates a cross-section view of an integrated circuit structure 100e (also referred to herein as "structure 100e") that is at least in part similar to the integrated circuit structure 100 of Fig. 1A, and where a gate electrode 127 of the upper device 101 and a gate electrode 177 of the lower device 140 are conductively coupled, in accordance with an embodiment of the present disclosure. Thus, for example, in the structure 100e of Fig. 1E, the isolation region 150 between the gate electrode 127 of the upper device 101 and the gate electrode 177 of the lower device 140 may be absent, to provide a common gate connection between the devices 101, 140. The discussion with respect to the structure 100 of Fig. 1A also applies to the structure 100e of Fig. 1E.

**Fig. 1F** illustrates an integrated circuit structure 100f that is similar to the integrated circuit structure 100 of Fig. 1A, but without backside gate contacts for the lower device 140, in accordance with an embodiment of the present disclosure. For example, in Fig. 1F, for the outer two gate stacks, a gate electrode 127 of the upper device 101 is in contact with a corresponding gate electrode 177 of the lower device 140. That is, the isolation region 150 (see Fig. 1A) is absent between those gate stacks of the upper and lower devices. Thus, in Fig. 1F, each of the two outer gate stacks 172 of the lower devices 140 is frontside-accessed from the corresponding gate contacts 125 of the upper device 101. In this example of Fig. 1F, the structure 100f is formed on a substrate 179, and the source and drain contacts 128a 128b of the lower device 140 and the liner 102 extends through the substrate 179.

Note that Fig. 1A illustrates embedded source and drain contacts for stacked devices 101, 140. However, the embedded source or drain contacts may also be used for a non-stacked device. For example, embedded source contact 118a and embedded drain contact 118b may be formed for the device 101, even when the device 101 is not stacked above the device 140. Similarly, embedded source contact 128a and embedded drain contact 128b may be formed for the device 140, even when the device 140 is not stacked below the device 101. For example, **Fig. 1G** illustrates a cross-section view of an integrated circuit structure 100g including a device comprising (i) a first source contact and a first drain contact, (ii) remnants 133a of a first core region of a source region of the device, and (iii) remnants 133b of a second core region of a drain region of the device, wherein at least a central section of a core region of a source or drain region is removed during formation of a corresponding source or drain contact, leaving behind the remnants 133a-b of the core region, in accordance with an embodiment of the present disclosure. The structure 100g of Fig. 1G is at least in part similar the structure 100 of Fig. 1A. However, unlike the stacked device architecture of Fig. 1A, Fig. 1G comprises a single device 101 having the source contact 118a, drain contact 118b, and remnants 133a-b of the core regions. In an example, instead of being formed above a lower device, the device 101 of Fig. 1G is formed above a substrate 180.

**Figs. 2A****,** **2B** illustrate a flowchart depicting a method 200 of forming the example nanoribbon semiconductor structure 100 of Fig. 1A, in accordance with an embodiment of the present disclosure. **Figs. 3A****,** **3B**, 3B1, 3C, 3D, 3D1, 3E, 3F, 3G, 3H, 3I, 3I1, 3J, 3J1, 3K, 3L, 3M, and 3N collectively illustrate cross-sectional views of an example semiconductor structure (e.g., the semiconductor structure 100 of Fig. 1A) in various stages of processing, in accordance with an embodiment of the present disclosure. Figs. 2A, 2B, and 3A-3N will be discussed in unison. The cross-sectional views of Figs. 3A-3N correspond to the cross-sectional view of Fig. 1A.

Referring to Fig. 2A, the method 200 includes, at 204, for each of the vertically stacked devices 101 and 140, forming one or more fins 301 comprising alternating layers of sacrificial material 309 and channel material 103, and forming dummy gates 325, 375, as illustrated in Fig. 3A. For example, fins 301a, 301b, 301c are illustrated to be formed in Fig. 3A. The channel materials 103a within an upper portion of individual fins 301 will eventually form nanoribbons 103a of the upper device, and the channel materials 103b within a lower portion of individual fins 301 will eventually form nanoribbons 103b of the lower device. In an example, the upper and lower portions of individual fins 301 are separated by corresponding isolation region 150, as illustrated in Fig. 3A. As discussed herein previously, the channel material 103b of the lower portions of the fins 301 may be suitable for nanoribbons of the lower device 140, and the channel material 103a of the upper portions of the fins 301 may be suitable for nanoribbons of the upper device 101. In an example, the sacrificial material 309 may be an appropriate sacrificial material used to form nanoribbon transistors (or other GAA transistors, such as nanosheet or nanowire transistors), and may be etch selective to the channel material 309 (e.g., an etch process to etch the sacrificial material 309 during releasing the nanoribbons may not substantially etch, or etch at a lower rate, the channel material 103). Also illustrated in Fig. 3A are gate spacers 132 on sides of the fins 301, where the alternating layers of channel material 103 extends within, and extends through, the gate spacers 132. Further illustrated in Fig. 3A are the dummy gates 325a, 325b, 325c (e.g., comprising polysilicon or another appropriate dummy gate material) on top surfaces of individual fins 301 for the upper device 101, and the dummy gates 375a, 375b, 375c (e.g., comprising polysilicon or another appropriate dummy gate material) on bottom surfaces of individual fins 301 for the lower device 140.

In an example, the structure 100 illustrates in Fig. 3A is formed on a substrate 300. Embedded within the substrate 300 are a first conductive structure 310a formed below a location where the source region 106c of the lower device 140 is to be eventually formed, and a second conductive structure 310b formed below a location where the drain region 106d of the lower device 140 is to be eventually formed. In an example where the source and/or drain regions of the lower device 140 is to be formed from the frontside of the die, the conductive structures 310a, 310b may be respectively used for interconnections of the source and drain regions of the lower device 140. However, in the example process flow of the method 200 of Fig. 2A, the source and drain regions of the lower device 140 are to be formed from the backside of the die, and hence, the conductive structures 310a, 310b would eventually be removed later in the process. In an example, the structure illustrated in Fig. 3A, including the fins 301, the gate spacers 132, and the dummy gates 325, 375 are formed using an appropriate process for forming these elements of a vertically stacked GAA device structure.

Referring again to Fig. 2A, the method 200 proceeds from 204 to 208, where from the frontside (e.g., top of the structure 100), source region 106c and drain region 106d of the lower device 140 are formed. In an example, each of the source region 106c and the drain region 106d comprises a corresponding nucleation layer 104, a main layer 105, and a core layer 133, as illustrated in Figs. 3B and 3B1. For example, the source region 106c comprises the nucleation layer 104c, the main layer 105c, and the core layer 133c. Similarly, the drain region 106d comprises the nucleation layer 104d, the main layer 105d, and the core layer 133d.

In an example, the nucleation layer 104 is grown to be adjacent to the channel material 103 and the gate spacers 132. The main layer 105 is grown epitaxially on walls the nucleation layer 104 and also on the top surface of dielectric material 315. In an example, the epitaxial growth of each of the main regions 105c, 105d may be timed to not merge, such that there is a recess 333 between the epitaxial growths of each of the main regions 105c, 105d, as illustrated in Fig. 3B. For example, the recess 333 extends within the main region 105c, and also within the main region 105d, see Fig. 3B. Subsequently, as illustrated in Fig. 3B1, the core region 113c is formed (e.g., epitaxially grown) within the opening 333 of the source region 106c, and the core region 113d is formed within the opening 333 of the drain region 106d. As illustrated, a top portion of the core region 133c is above the top surface of the main region 105c, and a top portion of the core region 133d is above the top surface of the main region 105d, as illustrated in Fig. 3B1. Example materials and doping concentration for the main and core regions have been discussed herein previously, e.g., with respect to Fig. 1A.

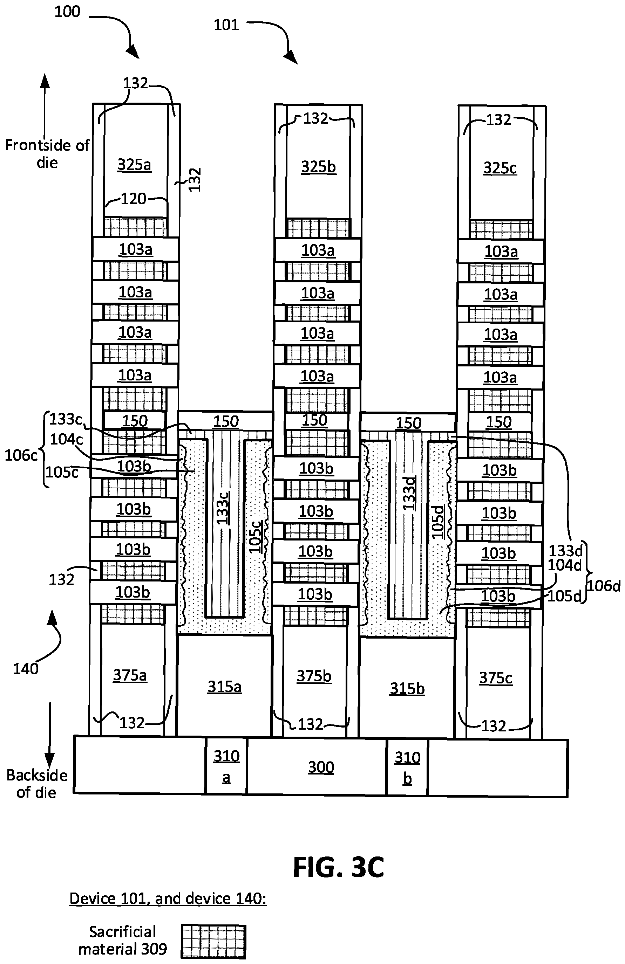

Referring again to Fig. 2A, the method 200 proceeds from 208 to 212, where isolation structure 150 is formed above the source region 106c, and another isolation structure 150 is formed above the drain region 106d of the lower device 140, as illustrated in Fig. 3C. As discussed herein previously, the isolation structure 150 comprises appropriate non-conductive material, and can be deposited using an appropriate deposition technique, such as chemical vapor deposition (CVD), physical vapor deposition (PVD), atomic layer deposition (ALD), vapor-phase epitaxy (VPE), molecular beam epitaxy (MBE), or liquid-phase epitaxy (LPE), for example.

Referring again to Fig. 2A, the method 200 proceeds from 212 to 216, where from the frontside, source region 106a and drain region 106b of the upper device 101 are formed, and then dielectric material 315m and 315n are deposited respectively above the source region 106a and drain region 106b of the upper device 101, e.g., as illustrated in Fig. 3D and 3D1. For example, Fig. 3D illustrates formation of the source region 106a and drain region 106b of the upper device 101, and Fig. 3D1 illustrates deposition of the dielectric material 315m and 315n respectively above the source region 106a and drain region 106b of the upper device 101. In an example, each of the source and drain regions of the upper device 101 comprises a corresponding nucleation layer 104, a main layer 105, and a core layer 106, as illustrated in Fig. 3D. Formation of these regions have been discussed with respect to the source and drain regions of the lower device 140, e.g., with respect to process 208 and Fig. 3B and 3B1 herein previously.

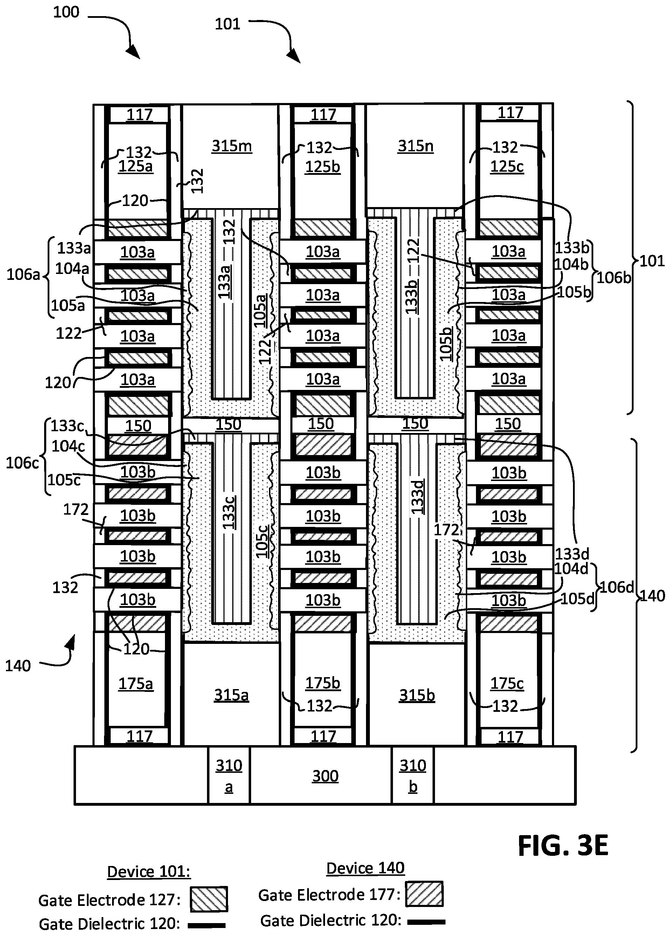

Referring again to Fig. 2A, the method 200 proceeds from 216 to 220, where the nanoribbons 103a, 103b of the upper and lower devices 101, 140 are released by removing the dummy gates 125, 175 to expose the respectively channel regions and by selectively removing the sacrificial material 309 from exposed the channel regions, and then the final gate stacks 122, 172 are formed, e.g., as illustrated in Fig. 3E. Thus, in the process 220, a major portion of the vertically stacked devices 101 and 140, except, for example, the respective source and drain contacts, are formed. The process 220 may include any appropriate techniques for releasing the nanoribbons, and forming replacement metal gate (RMG) stack of a GAA device architecture having two vertically stacked GAA device, such as devices 101 and 140. As illustrated in Fig. 3E, after process 220, the source and drain contacts of the upper and lower devices have not yet formed, and the source and drain regions of individual devices are covered by respective dielectric materials 315.

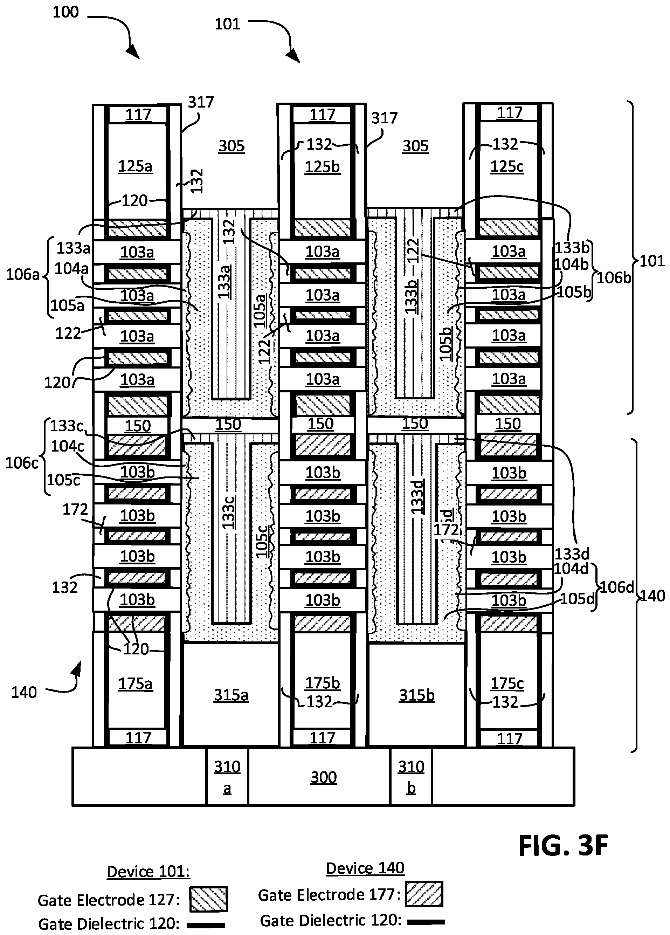

Referring again to Fig. 2A, the method 200 then proceeds from 220 to 224, where for the upper device 101, the dielectric material 315m, 315n are removed (e.g., etched) to expose the underlying source region 106a and the drain region 106b, as illustrated in Fig. 3F. As a result, openings 305 are formed above the source region 106a and the drain region 106b of the upper device 101. In an example, at process 220, the source and drain trenches are opened for the upper device 101, and not for the lower device 140.

Referring again to Fig. 2A, the method 200 then proceeds from 224 to 228, where for the upper device 101, (i) a liner 102 is formed on walls 317 of the upper portion of the gate spacers 132, above the gate contacts 125a, 125b, and 125c, and partially above the source region 106a and drain region 106b, and (ii) a protective layer 304 is formed on top surface of the liner 102, where the liner 102 further defines the recesses or openings 305 above the top surface of the source region 106a and the drain region 106b, as illustrated in Figs. 3G and 3H.

For example, initially the layer of liner 102 is deposited on walls 317 of gate spacers 132, above the gate contacts 125, and above the source region 106a and drain region 106b, and a protective layer 304 is deposited on top surfaces of the liner 302, as illustrated in Fig. 3G. The protective layer 304 allows the lower lateral portion of liner 102 to be selectively removed from above at least a corresponding section of the source region 106a and the drain region 106b. For example, the liner 302 may initially be deposited on walls of the gate spacers 132 and also above the source region 106a, as illustrated in Fig. 3G. Subsequently, protective layer 304 is selectively deposited on the upper layer of liner 102 and less so on the lower surface of 102 given, for example, a directional nature of the deposition and/or aspect ratio of trench 305 (e.g., trench 305 is five or more time taller than it is wide, and is even narrower once liner 302 is deposited), according to an embodiment. With the protective layer 304 in place, the horizontal section of the liner 102 partially above the top surfaces of the source and drain regions of the upper device 101 may then be etched and removed from above the source and drain regions 106a, 106b, such that the liner remains on walls 317 of gate spacers 132, above the gate contacts 125, and only partially above the source and drain regions, thereby once again extending opening 305 down to a surface of the source and drain regions, as illustrated in Fig. 3H. A directional etch that is selective to the material of protective layer 304 can be used to remove that portion of liner 102. Note that, in some cases, protective layer 304 may also deposit on top of that portion of liner 102, but that lower layer 304 is thinner than the upper layer 304 (e.g., because is it more difficult to deposit layer 304 into the trench 305 that is now even narrower due to presence of liner 302, particularly when a directional deposition is used to provide protective layer 304), and that thinner portion of the layer 304 can thus be completely removed along with liner 102 by the directional etch, while at least some of the thicker upper portion of layer 304 survives the selective etch. As illustrated, the liner 102 defines a recess or opening 305 above a top surface of the source region 106a, and also defines another recess or opening 305 above a top surface of the drain region 106b. In an example, the liner 102 may also be deposited above the gate stack, including the gate electrode 125. The liner 102 and the protective layer 304 may each be deposited using an appropriate deposition technique, such as CVD, PVD, ALD, VPE, MBE, or LPE, for example. As explained above, a directional deposition may be used for the protective layer 304, to facilitate its selective or otherwise more substantial deposition on the upper surface of the structure, relative to the lower surface within trench 305. In an example, when the horizontal section of the liner 102 above the source and drain regions are removed (see Figs. 3G and 3H), the helmet 304 may protect the vertical section of the liner 102 on walls of the spacers 132 from being substantially etched.

In an example, a thickness or width of the liner 102 (as may be trimmed by the directional etch described above) dictates a width of the opening, which in turn dictates the width of the source contact 118a and drain contact 118b to be eventually formed. In an example, the liner 102 and the protective layer 304 are both etch selective with respect to the material of the core regions 133a, 133b. For example, an etch process that etches the core regions 133a, 133b may not substantially etch (or etch at a substantially slower rate) the liner 102 or protective layer 104. As will be seen herein later in turn, the liner 102 protects the gate spacers 132 and the gate electrode 125, when recesses for a source contact and a drain are respectively formed within the core region 133a and core region 133b. An example of the liner 102 may comprises silicon nitride, or another appropriate nitride, oxide, carbide, oxycarbide, oxynitride, or oxycarbonitride.

Also, note that in an example, the protective layer 304 acts as a "helmet" in the sense that it protects the liner 102, e.g., when the recesses within the core region 133 of the source and drain regions are formed (discussed herein later). Similar to the liner 102, the protective layer 304 also is etch selective to the material of the core regions. In an example, the protective layer 304 comprises an appropriate nitride, oxide, carbide, oxycarbide, oxynitride, or oxycarbonitride, for example, titanium nitride (TiN).

Referring again to Fig. 2A, the method 200 then proceeds from 228 to 232, where a portion of the core region 133a of the source region 106a and a portion of the core region 133b of the drain region 106b are removed through the openings 305, so as to extend the openings 305 within the source and drain regions of the upper device 101, as illustrated in Fig. 3I. An anisotropic or directional etch is performed, to extend the respective openings 305 within the respective core regions 133a, 133b. The etch process is selective to the liner 102, the protective layer 304, and the main regions 104a, 104b, such that a rate of etching the core regions 133a, 133b is substantially faster than a rate of etching the liner 102, the main regions 105a, 105b, and/or the protective layer 304. Accordingly, after the etch process 232, the liner 102 and the protective layer 304 continue to cover the walls of the gate spacer 132 and the gate electrode 125. Furthermore, the main regions 105a, 105b are not substantially etched, and the openings 305 now extend within the corresponding main regions 105a, 105b. Note that portions of the core region 133a and 133b, which were under the liner 102, are not etched (e.g., protected by the liner 102), and remain as remnants of the core regions 133a, 133b, as illustrated in Fig. 3I.

In an example, a bottom horizontal section of the main regions 105a, 105b are also etched, as illustrated in Fig. 3I1. In the etch process illustrated in Fig. 3I1, the isolation regions 150 may act as an etch stop layer. Accordingly, the openings 305 may extend through the corresponding main regions 105a, 105b and up to the corresponding isolation regions 105a, 105b.

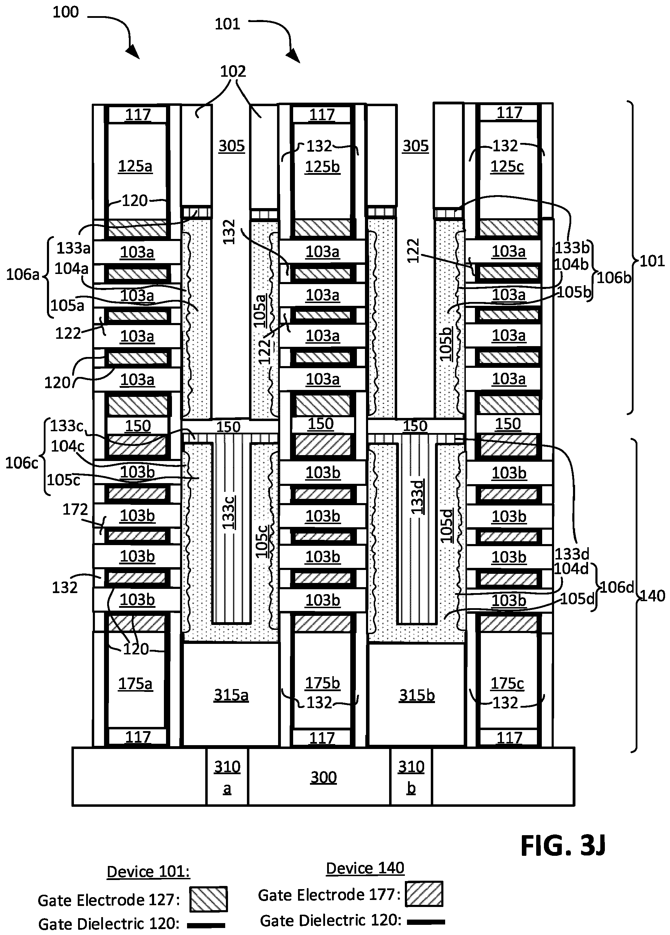

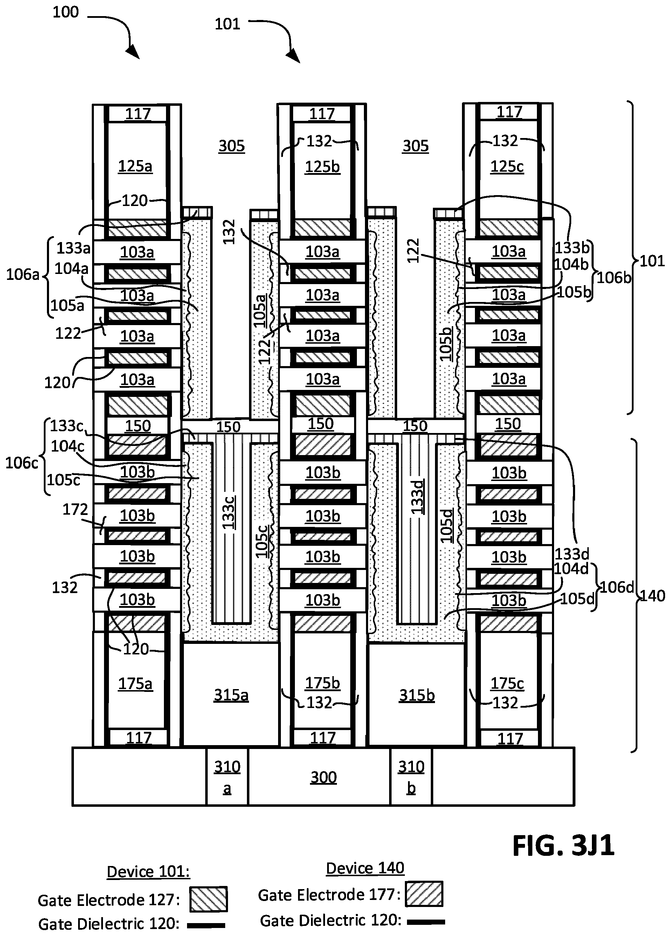

Referring again to the method 200, the method 200 then proceeds from 232 in Fig. 2A to 236 in Fig. 2B. At 236, the protective layer 304 and at least a horizontal section of the liner 102 are removed, e.g., etched using an appropriate etching technique, as illustrated in Fig. 3J. In the example of Fig. 3J, portions of the liner 102, which are on the sidewalls of the spacers 132, remain. Thus, the structure of Fig. 3J results in the liner 102 being above the remnants of the core regions 133a, 133b, as also discussed with respect to Fig. 1A.

In contrast, in Fig. 3J1, the liner 102 is substantially removed, which also includes removal of the liner 102 on sidewalls of the spacers 132. Thus, the space above the remnants of the core regions 133a, 133b are not occupied by the liner 102, and this space will eventually be filed with conductive source and drain contacts, e.g., as also discussed with respect to Figs. 1B. Whether the liner 102 on sidewalls of the spacers 132 is fully or partially removed, or not substantially removed, depends on the specific etch techniques employed to remove the liner 102. Thus, depending on whether the liner 102 on sidewalls of the spacers 132 is fully or partially removed, or not substantially removed, the final structure of the devices 101, 140 would be similar to that of structure 100 of Fig. 1A or structure 100b of Fig. 1B.

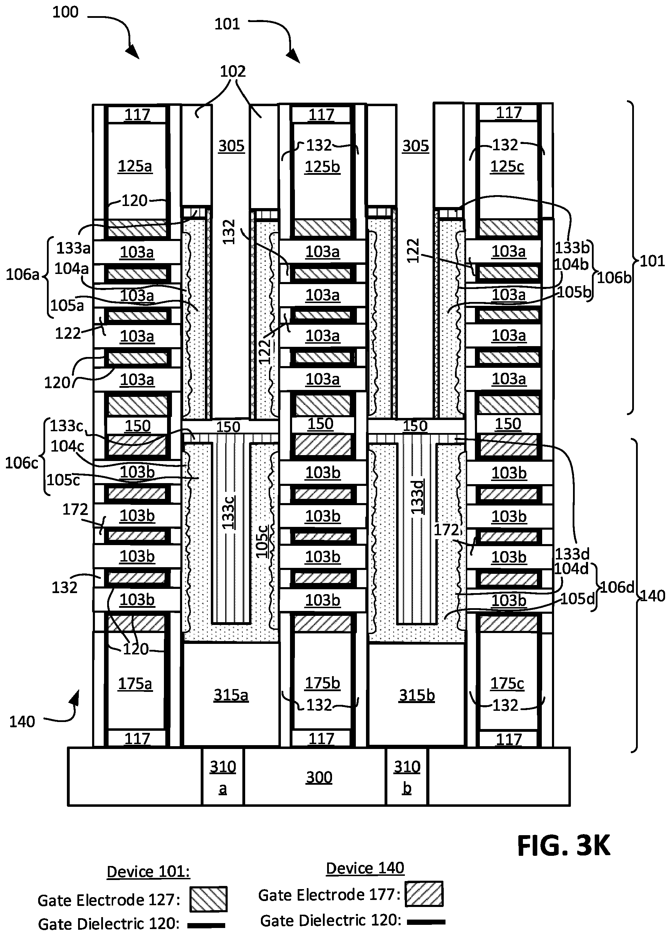

Referring again to Fig. 2, the method 200 then proceeds from 236 to 240, where the lining layer 135 is deposited on sidewalls of the opening 305 (e.g., see Fig. 3K), and subsequently annealed. In an example, the conductive lining layer 135 is representative of one or more silicide layer(s), germanide layer(s), and/or adhesive layer(s) between the conductive source or drain metal contact and the adjacent source or drain region. In an example, the lining layer 135 reduces contact resistance of the source and drain contacts. The lining layer 135 may be deposited using an appropriate deposition technique, such as CVD, PVD, ALD, VPE, MBE, or LPE, and then annealed, to form the desired silicide layer(s) or germanide layer(s), for example.

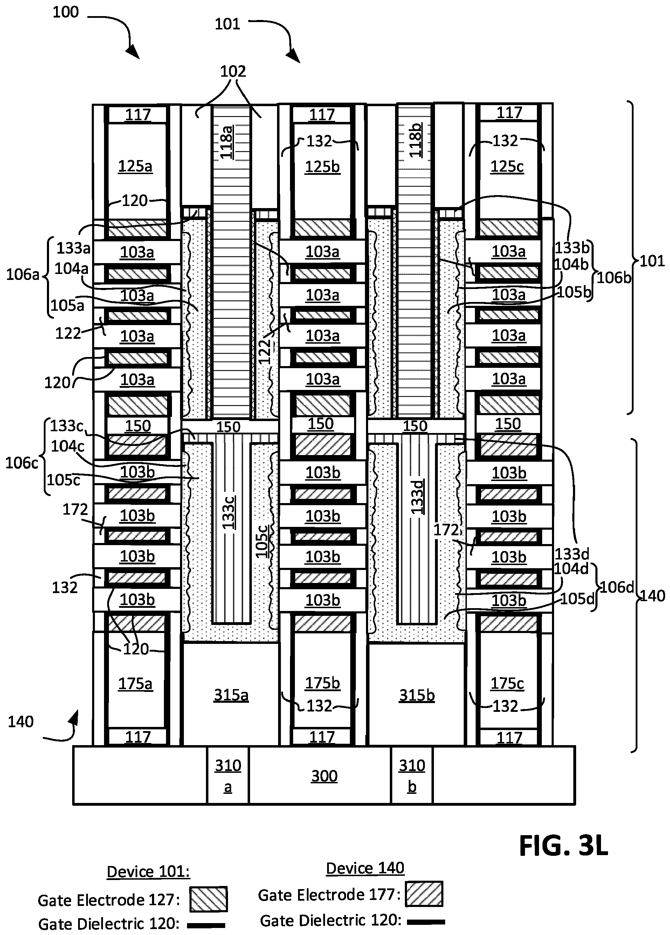

Referring again to Fig. 2B, the method 200 then proceeds from 240 to 244, where conductive material are deposited within the respective openings 305 extending within the source region 106a and the drain region 106b of the upper device 101, to respectively form the source contact 118a and drain contact 118b of the upper device 101, as illustrated in Fig. 3L. In an example, the deposited conductive materials may be planarized using an appropriate planarization technique, such as mechanical polishing or chemical-mechanical polishing (CMP). This completes formation of the source and drain contacts 118a, 118b of the upper device 101.

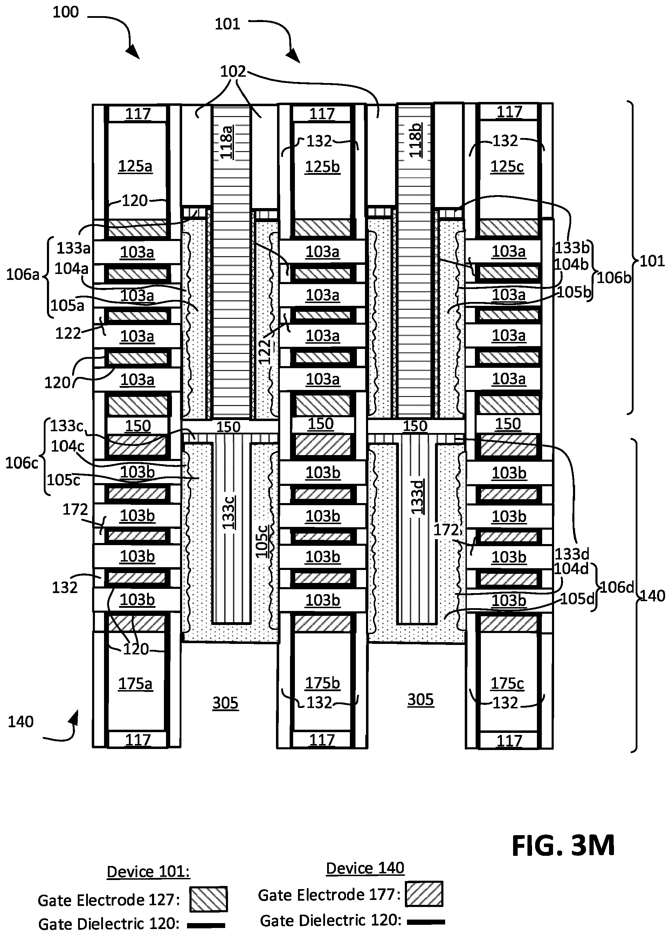

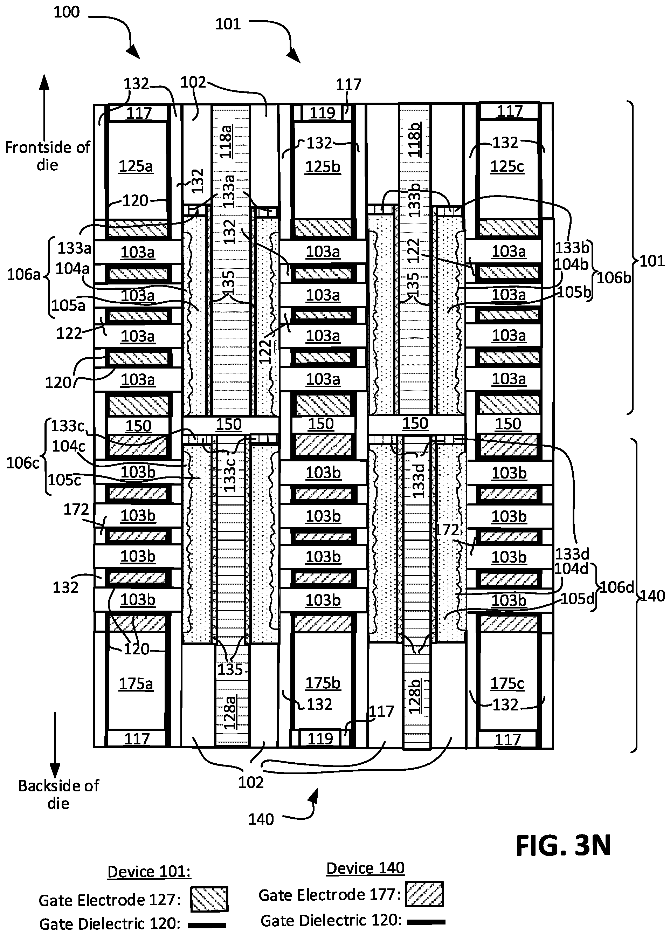

Referring again to Fig. 2B, the method 200 then proceeds from 244 to 248. At 248, the processes 224, 228, 232, 236, 240, and 244 are repeated for the lower device 140, to form source contact 128a and drain contact 128b of the lower device 140. Note that during repetition of these processes for the lower device 140, the structure 100 may be flipped upside-down (e.g., while being supported by a carrier wafer on a top surface of the upper device 101), such that the device 140 is above the device 101 (although Figs. 3M and 3N illustrate the structure 100 within showing the flipping, and also without showing the carrier wafer).

For example, Fig. 3M illustrates for the lower device 140, opening the source and drain trenches, e.g., by removing the substrate 300 and/or the dielectric material 310a, 310b adjacent to the source region 106c and the drain region 106d, to expose the source region 106c and the drain region 106d, e.g., which is a repetition of the process 244 for the lower device 140. Similarly, other processes 228, 232, 236, 240, and 244 are also repeated for the device 140, to form the source contact 128a and the drain contact 128b for the lower device 140, as illustrated in Fig. 3N. Thus, Fig. 3N illustrates, after completion of the process 248, source and drain contacts 118a, 118b of the device 101, as well as source and drain contacts 128a, 128b of the device 140.

The method 200 of Fig. 2B then proceeds from 248 to 252, where a general integrated circuit (IC) is completed, as desired, in accordance with some embodiments. Such additional processing to complete an IC may include forming frontside and/or backside contact vias 119 through dielectric material 117 (e.g., to contact corresponding gate contacts 125b, 175b, such as shown in Fig. 3N), back-end or back-end-of-line (BEOL) processing to form one or more frontside and/or backside metallization layers (e.g., such as a frontside logic interconnect structure and/or a backside power delivery network structure). Any other suitable processing may be performed, as will be apparent in light of this disclosure.

Note that the processes in method 200 are shown in a particular order for ease of description. However, one or more of the processes may be performed in a different order or may not be performed at all (and thus be optional), in accordance with some embodiments. Numerous variations on method 200 and the techniques described herein will be apparent in light of this disclosure.

### Example System

**Fig. 4** illustrates a computing system 1000 implemented with integrated circuit structures formed using the techniques disclosed herein, in accordance with some embodiments of the present disclosure. As can be seen, the computing system 1000 houses a motherboard 1002. The motherboard 1002 may include a number of components, including, but not limited to, a processor 1004 and at least one communication chip 1006, each of which can be physically and electrically coupled to the motherboard 1002, or otherwise integrated therein. As will be appreciated, the motherboard 1002 may be, for example, any printed circuit board, whether a main board, a daughterboard mounted on a main board, or the only board of system 1000, etc.

Depending on its applications, computing system 1000 may include one or more other components that may or may not be physically and electrically coupled to the motherboard 1002. These other components may include, but are not limited to, volatile memory (e.g., DRAM), nonvolatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1000 may include one or more integrated circuit structures or devices formed using the disclosed techniques in accordance with an example embodiment. In some embodiments, multiple functions can be integrated into one or more chips (e.g., for instance, note that the communication chip 1006 can be part of or otherwise integrated into the processor 1004).

The communication chip 1006 enables wireless communications for the transfer of data to and from the computing system 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing system 1000 includes an integrated circuit die packaged within the processor 1004. In some embodiments, the integrated circuit die of the processor includes onboard circuitry that is implemented with one or more integrated circuit structures or devices formed using the disclosed techniques, as variously described herein. The term "processor" may refer to any device or portion of a device that processes, for instance, electronic data from registers and/or memory to transform that electronic data into other electronic data that may be stored in registers and/or memory.

The communication chip 1006 also may include an integrated circuit die packaged within the communication chip 1006. In accordance with some such example embodiments, the integrated circuit die of the communication chip includes one or more integrated circuit structures or devices formed using the disclosed techniques as variously described herein. As will be appreciated in light of this disclosure, note that multi-standard wireless capability may be integrated directly into the processor 1004 (e.g., where functionality of any chips 1006 is integrated into processor 1004, rather than having separate communication chips). Further note that processor 1004 may be a chip set having such wireless capability. In short, any number of processor 1004 and/or communication chips 1006 can be used. Likewise, any one chip or chip set can have multiple functions integrated therein.

In various implementations, the computing system 1000 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device or system that processes data or employs one or more integrated circuit structures or devices formed using the disclosed techniques, as variously described herein. Note that reference to a computing system is intended to include computing devices, apparatuses, and other structures configured for computing or processing information.

### Further Example Embodiments

The following examples pertain to further embodiments, from which numerous permutations and configurations will be apparent.
Example 1. An integrated circuit structure, comprising: a device comprising (i) a source region, (ii) a drain region, (iii) one or more bodies comprising semiconductor material laterally extending from the source region to the drain region, and (iv) a source contact comprising a conductive material coupled to the source region, wherein the source region comprises (i) a first region, and (ii) a second region compositionally different from and above the first region, wherein the source contact extends through the second region and extends within the first region.
Example 2. The integrated circuit of example 1, wherein a doping concentration level of a dopant within the first region is different from a doping concentration level of the dopant within the second region.
Example 3. The integrated circuit of any one of examples 1-2, wherein a doping concentration level of a dopant within the second region is at least 50% more than a doping concentration level of the dopant within the first region.
Example 4. The integrated circuit of any one of examples 1-3, further comprising: dielectric material above the source region, such that the source contact extends through the dielectric material, to reach the source region, where at least a section of the second region is between a bottom surface of the dielectric material and a top surface of the first region.
Example 5. The integrated circuit of example 4, further comprising: a first gate spacer and a second gate spacer, such that a gate stack is between a lower section of the first gate spacer and a lower section of the second gate spacer, wherein the dielectric material is on a sidewall of an upper section of the first gate spacer.
Example 6. The integrated circuit of any one of examples 1-3, wherein: the source contact has an upper portion above the first region, and a lower portion extending within the first region; and at least a section of the second region is between (i) a lower surface of the upper portion of the source contact and (ii) an upper surface of the first region.
Example 7. The integrated circuit of any one of examples 1-6, wherein: the one or more bodies are laterally between the first region and the drain region, and not laterally between the second region and the drain region.
Example 8. The integrated circuit of any one of examples 1-7, wherein the device is a first device, the source region is a first source region, the drain region is a first drain region, the one or more bodies are first one or more bodies, the source contact is a first source contact, and wherein the integrated circuit further comprises: a second device below the first device, the first and second device is a vertical stack of devices, the second device comprising (i) a second source region, (ii) a second drain region, and (iii) one or more second bodies comprising semiconductor material laterally extending from the second source region to the second drain region, and (iv) a second source contact comprising a conductive material coupled to the second source region, wherein the second source region comprises (i) a third region, and (ii) a fourth region compositionally different from and above the first region, wherein the second source contact extends through the third region and extends at least up to the fourth region.
Example 9. The integrated circuit of example 8, further comprising: an isolation region comprising non-conductive material between the first source region and the second source region, wherein at least a section of the fourth region is between a bottom surface of the isolation region and a top surface of the third region.
Example 10. The integrated circuit of any one of examples 8-9, wherein each of the third and fourth source regions comprise silicon and germanium, with a concentration of germanium within the fourth region being higher than a concentration of germanium within the third region.
Example 11. The integrated circuit of any one of examples 8-10, wherein each of the third and fourth source regions comprise silicon and germanium, with a concentration of germanium within the fourth region being higher than a concentration of germanium within the third region by at least 10%.
Example 12. The integrated circuit of any one of examples 8-11, wherein the second device is a p-type MOS (PMOS) device.
Example 13. The integrated circuit of any one of examples 1-12, wherein the drain region comprises (i) a third region, and (ii) a fourth region compositionally different from and above the third region, wherein a drain contact extends through the fourth region and extends within the third region.
Example 14. The integrated circuit of any one of examples 1-13, wherein a height of the first region in the vertical direction is at least 3 times a height of the second region in the vertical direction.
Example 15. The integrated circuit of any one of examples 1-14, wherein the first device is a n-type MOS (NMOS) device.
Example 16. The integrated circuit of any one of examples 1-15, wherein the one or more bodies comprises a first nanoribbon and a second nanoribbon.
Example 17. The integrated circuit of any one of examples 1-16, further comprising a gate structure at least partially wrapped around the one or more bodies.
Example 18. The integrated circuit of any one of examples 1-17, wherein the first device is a n-type MOS (NMOS) device, and wherein the second device is a p-type MOS (PMOS) device.
Example 19. An integrated circuit structure comprising: a first device stacked above a second device, wherein the first device comprises a first source region that includes (i) a first region, and (ii) a second region above the first region, wherein a doping concentration level of a dopant within the second region is at least 20% more than a doping concentration level of the dopant within the first region, and wherein the second device comprises a second source region that includes (i) a third region, and (ii) a fourth region above the third region, wherein each of the third and fourth source regions comprise silicon and germanium, with a concentration of germanium within the fourth region being higher than a concentration of germanium within the third region by at least 10%.
Example 20. The integrated circuit of example 19, wherein the first device is a n-type MOS (NMOS) device.
Example 21. The integrated circuit of any one of examples 19-20, wherein the second device is a p-type MOS (PMOS) device.
Example 22. The integrated circuit of any one of examples 19-21, wherein the doping concentration level of the dopant within the second region is at least twice the doping concentration level of the dopant within the first region.
Example 23. The integrated circuit of any one of examples 19-22, wherein the first source region comprises one of a p-type or n-type dopant, and the second source region comprises the other of the p-type or n-type dopant.
Example 24. The integrated circuit of any one of examples 19-23, wherein the dopant is phosphorous.
Example 25. The integrated circuit of any one of examples 19-24, wherein the first device and the second device are coupled in a complementary metal oxide semiconductor (CMOS) architecture.
Example 26. The integrated circuit of any one of examples 19-25, wherein the first device and the second device are separated by a non-conductive isolation region.
Example 27. The integrated circuit of any one of examples 19-26, wherein the first device further comprises: a drain region; a body comprising semiconductor material laterally extending between the first source region and the drain region; and a gate structure at least partially wrapped around the body.
Example 28. The integrated circuit of any one of examples 19-27, wherein the second device further comprises: a drain region; a body comprising semiconductor material laterally extending between the second source region and the drain region; and a gate structure at least partially wrapped around the body.
Example 29. A processor or memory comprising the integrated circuit of any one of examples 19-29.
Example 30. A method of forming a source or drain contact of a transistor device, the method comprising: forming a first portion of a source or drain region, the first portion defining a recess that extends at least in part within the first portion of the source or drain region; forming a second portion of the source or drain region, the second portion at least in part within the recess, wherein the second portion is etch selective with respect to the first portion; removing at least a section of the second portion of the source or drain region, to form an opening extending within the first portion of the source or drain region; and forming the source or drain contact that is at least in part within the opening extending within the first portion of the source or drain region.
Example 31. The method of example 30, wherein removing at least the section of the second portion of the source or drain region comprises: etching at least the section of the second portion of the source or drain region, without substantially etching the first portion of the source or drain region.
Example 32. The method of any one of examples 30-31, further comprising: subsequent to forming the second portion of the source or drain region and prior to removing at least a section of the second portion of the source or drain region, releasing one or more nanoribbons of the transistor device, and forming a gate stack that at least in part wraps around the one or more nanoribbons.
Example 33. The method of any one of examples 30-32, the first portion and the second portion are compositionally different.

The foregoing description of example embodiments of the present disclosure has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto.

## Claims

1. An integrated circuit structure, comprising:
a device comprising (i) a source region, (ii) a drain region, (iii) one or more bodies comprising semiconductor material laterally extending from the source region to the drain region, and (iv) a source contact comprising a conductive material coupled to the source region,
wherein the source region comprises (i) a first region, and (ii) a second region compositionally different from and above the first region, wherein the source contact extends through the second region and extends within the first region.

2. The integrated circuit of claim 1, wherein a doping concentration level of a dopant within the first region is different from a doping concentration level of the dopant within the second region.

3. The integrated circuit of claim 1 or 2, wherein a doping concentration level of a dopant within the second region is at least 50% more than a doping concentration level of the dopant within the first region.

4. The integrated circuit of any one of claims 1 through 3, further comprising:
dielectric material above the source region, such that the source contact extends through the dielectric material, to reach the source region, where at least a section of the second region is between a bottom surface of the dielectric material and a top surface of the first region.

5. The integrated circuit of any one of claims 1 through 3, wherein:
the source contact has an upper portion above the first region, and a lower portion extending within the first region; and
at least a section of the second region is between (i) a lower surface of the upper portion of the source contact and (ii) an upper surface of the first region.

6. The integrated circuit of any one of claims 1 through 5, wherein:
the one or more bodies are laterally between the first region and the drain region, and not laterally between the second region and the drain region.

7. The integrated circuit of any one of claims 1 through 6, wherein the device is a first device, the source region is a first source region, the drain region is a first drain region, the one or more bodies are first one or more bodies, the source contact is a first source contact, and wherein the integrated circuit further comprises:
a second device below the first device, the first and second device is a vertical stack of devices, the second device comprising (i) a second source region, (ii) a second drain region, and (iii) one or more second bodies comprising semiconductor material laterally extending from the second source region to the second drain region, and (iv) a second source contact comprising a conductive material coupled to the second source region,
wherein the second source region comprises (i) a third region, and (ii) a fourth region compositionally different from and above the first region, wherein the second source contact extends through the third region and extends at least up to the fourth region.

8. The integrated circuit of claim 7, further comprising:
an isolation region comprising non-conductive material between the first source region and the second source region,
wherein at least a section of the fourth region is between a bottom surface of the isolation region and a top surface of the third region.

9. The integrated circuit of claim 7 or 8, wherein each of the third and fourth source regions comprise silicon and germanium, with a concentration of germanium within the fourth region being higher than a concentration of germanium within the third region.

10. The integrated circuit of any one of claims 7 through 9, wherein each of the third and fourth source regions comprise silicon and germanium, with a concentration of germanium within the fourth region being higher than a concentration of germanium within the third region by at least 10%.

11. The integrated circuit of any one of claims 7 through 10, wherein the second device is a p-type MOS (PMOS) device.

12. The integrated circuit of any one of claims 1 through 11, wherein the drain region comprises (i) a third region, and (ii) a fourth region compositionally different from and above the third region, wherein a drain contact extends through the fourth region and extends within the third region.

13. The integrated circuit of any one of claims 1 through 12, wherein a height of the first region in the vertical direction is at least 3 times a height of the second region in the vertical direction.

14. The integrated circuit of any one of claims 1 through 13, wherein the first device is a n-type MOS (NMOS) device.

15. A method of forming a source or drain contact of a transistor device, the method comprising:
forming a first portion of a source or drain region, the first portion defining a recess that extends at least in part within the first portion of the source or drain region;
forming a second portion of the source or drain region, the second portion at least in part within the recess, wherein the second portion is etch selective with respect to the first portion;
removing at least a section of the second portion of the source or drain region, to form an opening extending within the first portion of the source or drain region; and
forming the source or drain contact that is at least in part within the opening extending within the first portion of the source or drain region.
